(19) Europäisches Patentamt
European Patent Office
Office européen des brevets

(11) EP 2 685 552 A1

(12) **EUROPEAN PATENT APPLICATION**
published in accordance with Art. 153(4) EPC

(43) Date of publication:
**15.01.2014 Bulletin 2014/03**

(21) Application number: **12755311.3**

(22) Date of filing: **09.03.2012**

(51) Int Cl.:
***H01M 14/00*** *(2006.01)* ***C09B 57/00*** *(2006.01)*
***H01L 31/04*** *(2006.01)*

(86) International application number:
**PCT/JP2012/056205**

(87) International publication number:
**WO 2012/121397 (13.09.2012 Gazette 2012/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.03.2011 JP 2011053597**

(71) Applicant: **Kyoto University**
**Kyoto-shi, Kyoto 606-8501 (JP)**

(72) Inventors:
- **WAKAMIYA, Atsushi**
**Uji-shi**
**Kyoto 611-0011 (JP)**
- **TANIGUCHI, Takuhiro**
**Uji-shi**
**Kyoto 611-0011 (JP)**
- **MURATA, Yasujiro**
**Uji-shi**
**Kyoto 611-0011 (JP)**
- **DY, Joanne Ting**
**Tokyo 153-8904 (JP)**
- **SEGAWA, Hiroshi**
**Tokyo 153-8904 (JP)**

(74) Representative: **Vossius & Partner**
**Siebertstrasse 4**
**81675 München (DE)**

(54) **ORGANIC DYE MATERIAL AND DYE-SENSITIZED SOLAR CELL USING SAME**

(57) Provided is an inexpensive and high-performance dye compound that does not use an expensive precious metal and does not require the use of a strong electron-withdrawing group. The compound is formed such that a boron substituent is introduced into a heteroatom-containing $\pi$ electron-based backbone containing a double bond between carbon and the heteroatom to obtain a compound in which a backbone having boron and a coordination bond in a molecule thereof is used as a $\pi$ electron-accepting backbone.

EP 2 685 552 A1

## Description

### Technical Field

The present invention relates to an organic dye materials and dye-sensitized solar cells using the same.

### Background Art

Research is being actively conducted on organic dye-sensitized solar cells for use as next-generation solar cells. Although photoelectric conversion efficiency of 11% has been achieved thus far using ruthenium complex dyes, it will be necessary to realize even higher levels of photoelectric conversion efficiency in order to achieve practical application, and since the ruthenium complex uses ruthenium, which is a member of the platinum family and therefore expensive, the development of a dye that offers both low cost and high performance is sought.

On the other hand, although organic dyes that do not use a ruthenium complex exist, nearly all such dyes that have been reported thus far are obtained by introducing a strong electron-withdrawing group, such as a cyanoacrylate group, into a conventional electron-donating dye to serve as an anchoring unit for anchoring to titanium dioxide.

The most important strategy for realizing high photoelectric conversion efficiency is to allow light of a long wavelength to be absorbed by a compound serving as an organic dye material. Here, it is important that this compound have a suitable HOMO energy level (HOMO level) and LUMO energy level (LUMO level).

However, in the case of conventional organic dyes not using a ruthenium complex as described above, since long-wavelength absorbance is realized by forcibly lowering LUMO level as a result of introducing a strong electron-withdrawing cyanoacrylate group into an electron-donating backbone, the introduction of this unit is essential for obtaining high photoelectric conversion efficiency. Thus, it has been difficult to examine other functional groups for use as anchor units in an attempt to improve charge injection efficiency while also improving the stability of dye adsorption.

### Citation List

### Non-patent Literature

NPL 1: Amaresh Mishra, Markus K.R. Fischer, and Peter Bauerle, Angew. Chem. Int. Ed., 2009, 48, 2474-2499

### Summary of Invention

### Technical Problem

With the foregoing in mind, the main object of the present invention is to provide an inexpensive and high-performance dye compound that does not use an expensive precious metal and does not require the use of a strong electron-withdrawing group.

### Solution to Problem

The inventors of the present invention contrived the following matters as concepts for the molecular design of a novel organic dye material having high photoelectric conversion efficiency.

(1) Combining $\pi$ transition and intramolecular charge transfer transition

The following are realized as a result thereof.

(a) Absorption of sunlight not only in the visible light region, but also in the near-infrared region
(b) Inhibition of charge recombination due to rapid charge transfer

(2) Application of gradation to $\pi$ orbitals

The following are realized as a result thereof.

(a) High light absorption efficiency
(b) High charge separation efficiency

(3) Expansion of π conjugation

π-π* transitions are further shifted to the long wavelength region as a result thereof.

(4) Selectability of anchor backbone

The following are realized as a result thereof.

(a) Realization of improved charge injection efficiency
(b) Realization of long lifetimes of dye and device by improving adsorption ability of compound to titanium oxide

(5) Coating of π-conjugated backbone

The following are realized as a result thereof.

(a) Inhibition of self-assembly
(b) Inhibition of charge recombination

As a result of conducting extensive studies to achieve the above-mentioned objectives, the inventors of the present invention found that the above-mentioned problems can be solved by introducing a boron substituent into a heteroatom-containing π electron-based backbone containing a double bond between carbon and the heteroatom to obtain a compound in which a backbone having a coordination bond between boron and a heteroatom in a molecule thereof is used as a π electron-accepting backbone. Additional extensive studies were conducted based on this finding, thereby leading to completion of the present invention.

Namely, the present invention provides the compound indicated below.

1. A dye for a dye-sensitized solar cell, comprising: a compound having an anchor site A capable of bonding to a semiconductor electrode of an organic solar cell, and an acceptor site T bonding to the anchor side and having a π-conjugated backbone that has a boron-containing substituent represented by the formula: $-B(-X^1)(-X^2)$ (wherein $X^1$ and $X^2$ independently represent substituents), the π-conjugated backbone having as a constituent atom thereof a heteroatom that forms a double bond with carbon in the end region on the side of the anchor backbone and is coordinate-bonded to the boron of the boron-containing substituent.
2. The dye described in 1, wherein the compound is a compound having an acceptor site T and an anchor site A represented by the following general formula (1):

A-T (1)

(wherein T is composed of one or more partial structures represented by the following chemical formula (2a) or (2b) and having an intramolecular coordination bond to boron, and in the case where the number of the partial structures is two or more, adjacent partial structures are independent in each linkage and may be coupled directly based on any coupling scheme selected from $Ar^1$-$Ar^2$, $Ar^1$-$Ar^1$ and $Ar^2$-$Ar^2$,

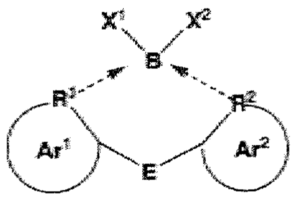
(2 a)

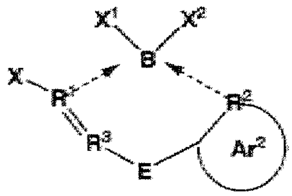
(2 b)

(wherein $Ar^1$ and $Ar^2$ respectively and independently represent one type selected from the group consisting of substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted benzothiazole, substituted or unsubstituted benzo(bis)thiazole, substituted

or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, and substituents on $Ar^1$ and $Ar^2$ may also bond to form a ring in formula (2a),

$R^1$ and $R^2$ respectively and independently represent one type selected from the group consisting of carbon, nitrogen and phosphorous, at least one of these is nitrogen or phosphorous having a coordination bond to boron, and $R^1$ represents nitrogen or phosphorous in formula (2b),

dotted-line arrows represent bonds that may be coordination bonds,

$R^3$ represents a carbon atom bonded to the anchor site A,

X, $X^1$ and $X^2$ respectively and independently represent one type selected from the group consisting of a hydrogen, halogen, substituted or unsubstituted alkyl group, substituted or unsubstituted aryl group, substituted or unsubstituted heteroaryl group, substituted or unsubstituted alkenyl group, substituted or unsubstituted alkynyl group, substituted or unsubstituted amino group, substituted or unsubstituted alkoxy group, substituted or unsubstituted arylalkoxy group and hydroxyl group, or a substituted or unsubstituted 2,2'-biphenyl group or substituted or unsubstituted 2,2'-bithienyl group obtained by bonding of $X^1$ and $X^2$, and

E represents one type selected from the group consisting of a direct bond, -CR=CR-, =CR-, >C=O, =N-, -NR-, -O-, -S-, -PR-, =P- and -P(O)R-, wherein R independently represents at the time of each appearance at least one type selected from the group consisting of a hydrogen, alkyl group, alkoxy group, alkylthio group, aryl group, heteroaryl group, polyethylenedioxy group, perfluoroalkyl group, cyano group, amino group, silyl group, nitro group, halogen and acyl group) ; and,

A represents a group capable of bonding to a semiconductor electrode that bonds on $Ar^1$ on the end of the acceptor site T, and is one type selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group; and an alkoxy group, alkyl group, alkenyl group, alkynyl group, cycloalkyl group, aryl group, heteroaryl group and dioxocyclobutenyl group having at least one functional group selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group).

3. The dye described in 1 or 2, wherein the acceptor site T in formula (1) contains a donor site D having an electron-donating backbone on the end on the opposite site to the anchor site A.

4. The dye described in 3, wherein the donor site D is at least one type selected from the group consisting of a triarylamine derivative, carbazole derivative, substituted or unsubstituted aryl group, substituted or unsubstituted amino group, substituted or unsubstituted arylalkoxy group and substituted or unsubstituted arylthioalkoxy group.

5. The dye described in 3 or 4, wherein the acceptor site T in formula (1) contains a spacer site Q having a $\pi$-conjugated backbone between the acceptor site T and the donor site D.

6. The dye described in 5, wherein the spacer site Q is at least one type selected from the group consisting of an alkenyl group, alkynyl group, substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, or substituents on Q may bond to form a ring.

7. A photovoltaic method comprising exposing to light a compound having an anchor backbone capable of bonding to a semiconductor electrode of an organic solar cell, and a $\pi$-conjugated backbone that bonds to the anchor backbone and contains one or more boron atoms as constituent atoms thereof, this $\pi$-conjugated backbone containing an intramolecular coordination bond to boron in the end region on the side of the anchor backbone.

8. A compound having an acceptor site T and an anchor site A represented by the following general formula (1):

A-T (1)

(wherein T is composed of one or more partial structures represented by the following chemical formula (2a) or (2b) and having an intramolecular coordination bond to boron, and in the case where the number of the partial structures

is two or more, adjacent partial structures are independent in each linkage and may be coupled directly based on any coupling scheme selected from $Ar^1$-$Ar^2$, $Ar^1$-$Ar^1$ and $Ar^2$-$Ar^2$.

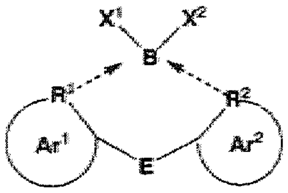
(2 a)

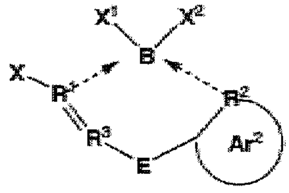
(2 b)

(wherein $Ar^1$ and $Ar^2$ respectively and independently represent one type selected from the group consisting of substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted benzothiazole, substituted or unsubstituted benzo(bis)thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, and substituents on $Ar^1$ and $Ar^2$ may also bond to form a ring in formula (2a),

$R^1$ and $R^2$ respectively and independently represent one type selected from the group consisting of carbon, nitrogen and phosphorous, at least one of these is nitrogen or phosphorous having a coordination bond to boron, and $R^1$ represents nitrogen or phosphorous in formula (2b),

dotted-line arrows represent bonds that may be coordination bonds,

$R^3$ represents a carbon atom bonded to the anchor site A,

X, $X^1$ and $X^2$ respectively and independently represent one type selected from the group consisting of a hydrogen, halogen, substituted or unsubstituted alkyl group, substituted or unsubstituted aryl group, substituted or unsubstituted heteroaryl group, substituted or unsubstituted alkenyl group, substituted or unsubstituted alkynyl group, substituted or unsubstituted amino group, substituted or unsubstituted alkoxy group, substituted or unsubstituted arylalkoxy group and hydroxyl group, or a substituted or unsubstituted 2,2'-biphenyl group or substituted or unsubstituted 2,2'-bithienyl group obtained by bonding of $X^1$ and $X^2$, and

E represents one type selected from the group consisting of a direct bond, -CR=CR-, =CR-, >C=O, =N-, -NR-, -O-, -S-, -PR-, =P- and -P(O)R-, wherein R independently represents at the time of each appearance at least one type selected from the group consisting of a hydrogen, alkyl group, alkoxy group, alkylthio group, aryl group, heteroaryl group, polyethylenedioxy group, perfluoroalkyl group, cyano group, amino group, silyl group, nitro group, halogen and acyl group); and,

A represents a group capable of bonding to a semiconductor electrode and bonding on $Ar^1$ on the end of the acceptor site T, and is one type selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group; and an alkoxy group, alkyl group, alkenyl group, alkynyl group, cycloalkyl group, aryl group, heteroaryl group and dioxocyclobutenyl group having at least one functional group selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group).

9. The compound described in 8, wherein the acceptor site T in formula (1) contains a donor site D having an electron-donating backbone on the end on the opposite site to the anchor site A.

10. The compound described in 9, wherein the donor site D is at least one type selected from the group consisting of a triarylamine derivative, carbazole derivative, substituted or unsubstituted aryl group, substituted or unsubstituted amino group, substituted or unsubstituted arylalkoxy group and substituted or unsubstituted arylthioalkoxy group.

11. The compound described in 9 or 10, wherein the acceptor site T in formula (1) contains a spacer site Q having a $\pi$-conjugated backbone between the acceptor site T and the donor site D.

12. The compound described in 11, wherein the spacer site Q is at least one type selected from the group consisting of an alkenyl group, alkynyl group, substituted or unsubstituted benzene, substituted or unsubstituted heterole, substituted or unsubstituted heterole oxide, substituted or unsubstituted benzoheterole, substituted or unsubstituted

benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, or substituents on Q may bond to form a ring.

13. A dye composed of any of the compounds described in 8 to 12.

14. A dye-sensitized solar cell, comprising:

a first electrode,
a light-absorbing layer formed on one side of the first electrode,
a second electrode arranged opposite the first electrode on which the light-absorbing layer is formed, and
a charge transport material positioned between the first electrode and the second electrode, wherein
the light-absorbing layer contains a metal oxide and the dye described in 13.

Advantageous Effects of Invention

The novel compound of the present invention is able to precisely control the expansion of $\pi$ orbitals ant $\pi^*$ orbitals and energy levels by introducing a heteroatom-containing $\pi$ electron-based backbone having an intramolecular coordination bond. As a result, a $\pi$-conjugated backbone can be constructed that has both light absorption efficiency, for which orbital expansion is important, and charge separation, for which orbital localization is important, and this can be expected to improve photoelectric conversion efficiency when used as a dye-sensitized material of a solar cell.

In addition, by combining $\pi$-$\pi^*$ transition by an acceptor site and spacer site with intramolecular charge transfer transition by a donor site, a dye can be obtained that has absorbance not only in the visible light region ($\pi$-$\pi^*$ transition), but also in the near-infrared region (intramolecular charge transfer transition), thereby making it possible to efficiently capture solar energy.

Description of Embodiments

The following provides a detailed explanation of the present invention.

1. Dye

The dye of the present invention is a dye for a dye-sensitized solar cell, namely an organic dye material.

This dye is a compound that has an anchor site A capable of bonding to a semiconductor electrode of an organic solar cell, and an acceptor site T that bonds to the anchor site and has a $\pi$-conjugated backbone having a boron-containing substituent represented by the formula: $-B(-X^1)(-X^2)$ (wherein $X^1$ and $X^2$ independently represent substituents), the $\pi$-conjugated backbone having as a constituent atom thereof a heteroatom that forms a double bond with carbon in the end region on the side of the anchor backbone and is coordinate-bonded to boron of the boron-containing substituent.

This compound may hereinafter simply be referred to as the compound of the present invention.

This compound has a lower LUMO level in comparison with compounds simply having a double bond between carbon and a heteroatom, since the heteroatom is coordinate-bonded to boron. In addition, since this coordination bond improves the planarity of the $\pi$-conjugated backbone, this compound has more preferable properties as an organic dye material for a dye-sensitized solar cell.

By selecting a substituent having suitable electron-withdrawing properties for the substituent represented by $X^1$ and the substituent represented by $X^2$ in the boron-containing substituent, the LUMO level of the compound can be further adjusted while maintaining expansion of the $\pi^*$ orbitals in the $\pi$-conjugated backbone. Here, if a substituent is selected having higher electron-withdrawing properties, the LUMO level can be lowered further. In addition, this substituent also functions as a coat between molecules and from electrolyte.

The $\pi$-conjugated backbone of this compound has as a constituent atom thereof a heteroatom that forms a double bond with carbon in the end region on the side of the anchor backbone and is coordinate-bonded to boron of the boron-containing substituent. As a result, HOMO is present in this region while a positive charge is isolated from the anchor backbone, or, in other words, is present at a distance from the electrode (anode). Consequently, charge is separated in this compound resulting in less susceptibility to the occurrence of charge reconsolidation.

On the other hand, due to the presence of the heteroatom coordinate-bonded to boron in this compound, $\pi$

orbitals and $\pi^*$ orbitals have gradation. Here, since HOMO, $\pi$ orbitals and $\pi^*$ orbitals are overlapping in this compound, oscillator strength is large.

Unlike the compound widely used as an anchor site in a dye for a dye-sensitized solar cell, the compound of the present invention can lower the LUMO level without using a group that attracts electrons by an inductive effect in the manner of a cyanoacrylate group. Therefore, it has a high degree of freedom for selection of the anchor site that bonds to titanium oxide.

Although this compound has preferable properties as a dye for a dye-sensitized solar cell even in the case of only being composed of an acceptor site T and an anchor site A in the case of having a $\pi$-conjugated backbone of adequate expansion, it preferably has a donor site having an electron-donating backbone, either directly or through a spacer site having $\pi$-conjugated backbone, at a location away from the anchor site A.

Groups, sites, units, and the like in this compound are suitably selected based on the main criteria of the compound having a suitable HOMO energy level (HOMO level) and LUMO energy level (LUMO level). Namely, preferable groups, sites, units and the like may differ according to other groups, sites, units and the like.

The compound of the present invention is preferably a compound represented by the following general formula (1) that has an acceptor site T and an anchor site A.

A-T (1)

The following provides a detailed explanation of this compound.

<u>(Acceptor Site T)</u>

Here, T is composed of one or more partial structures represented by the following chemical formula (2a) or (2b) that have an intramolecular coordination bond to boron, and in the case the number of the partial structures is two or more, adjacent partial structures are independent for each linkage and may be coupled directly based on any coupling scheme selected from $Ar^1$-$Ar^2$, $Ar^1$-$Ar^1$ and $Ar^2$-$Ar^2$.

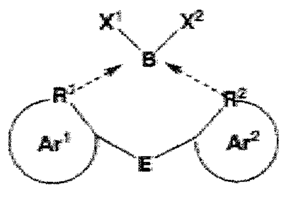
(2 a)

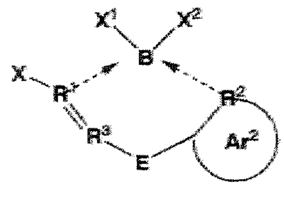
(2 b)

<u>(Acceptor Site T: $Ar^1$ and $Ar^2$ in Chemical Formula (2a) or (2b))</u>

In the above-mentioned chemical formula (2a) or (2b), $Ar^1$ and $Ar^2$ respectively and independently represent one type selected from the group consisting of substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted benzothiazole, substituted or unsubstituted benzo(bis)thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline. In addition, substituents on $Ar^1$ and $Ar^2$ may also bond to form a ring in formula (2a).

Examples of the heterole include thiophene, pyrrole, furan, phosphole and silole.

Examples of the heterole oxide include thiophene 1,1-dioxide and phosphole 1-oxide.

Examples of the benzoheterole include benzothiophene, indole, benzofuran, benzophosphole and benzosilole.

Examples of the benzoheterole oxide include benzothiophene 1,1-dioxide and benzophosphole 1-oxide.

Examples of the dibenzoheterole include dibenzothiophene, dibenzofuran, carbazole, dibenzophosphole and dibenzosilole.

Examples of the dibenzoheterole oxide include dibenzothiophene 5,5-dioxide and dibenzophosphole 5-oxide.

Examples of the fluorene derivative include fluorene, 9,9-dialkylfluorene, 9,9-diarylfluorene and 9-fluorenone.

Examples of the dithienoheterole include dithienothiophene, dithienopyrrole, dithienofuran, dithienophosphole and dithienosilole.

Examples of the dithienoheterole oxide include dithienothiophene 4,4-dioxide and dithienophosphole 4-oxide.

Examples of the thienoheterole include thienothiophene, thienopyrrole, thienofuran, thienophosphole and thienosilole.

Examples of the thienoheterole oxide include thienothiophene 1,1-dioxide and thienothiophene 1,1,4,4-tetraoxide.

Examples of the benzodiheterole include benzobithiophene, benzobifuran, benzobipyrrole, benzobiphosphole and benzobisilole.

Examples of the benzodiheterole oxide include benzobithiophene 5,5-dioxide.

Examples of the acene include naphthalene, anthracene, pentacene, pyrene, perylene and perylenebisimide.

Examples of substituents in $Ar^1$ and $Ar^2$ having substituents include an alkyl group, alkoxy group, alkylthio group, aryl group, heteroaryl group, polyethylenedioxy group, perfluoroalkyl group, cyano group, amino group, silyl group, nitro group, halogen and acyl group.

Examples of the alkyl groups include linear, branched and cyclic alkyl groups having 1 to 20 carbon atoms. Specific examples thereof include alkyl groups having 1 to 20 carbon atoms such as a methyl, ethyl, *n*-propyl, isopropyl, *n*-butyl, isobutyl, *sec*-butyl, *tert*-butyl, pentyl, cyclopentyl, hexyl, cyclohexyl, isohexyl, 2-ethylhexyl, octyl, decyl, dodecyl or icosyl group. Among these, a hexyl group or 2-ethylhexyl group is preferable, and a hexyl group is particularly preferable.

Examples of the alkoxy group include linear, branched and cyclic alkoxy groups having 1 to 20 carbon atoms. Specific examples thereof include alkoxy groups such as a methoxy group, ethoxy group, propoxy group, butoxy group, hexyloxy group, octyloxy group, decyloxy group, dodecyloxy group, icosyloxy group, ethylhexyloxy group or ethylenedioxy group. Among these, a hexyloxy group, ethylhexyloxy group or ethylenedioxy group is preferable.

Examples of the alkylthio group include linear, branched and cyclic alkylthio groups having 1 to 20 carbon atoms. Specific examples thereof include alkylthio groups such as a methylthio group, ethylthio group, propylthio group, butylthio group, hexylthio group, octylthio group, decylthio group, dodecylthio group, icosylthio group, ethylhexylthio group or ethylenedithio group. Among these, a hexylthio group or ethylhexylthio group is preferable.

Examples of the aryl group include monocyclic aryl groups and aryl groups having two or more rings, and specific examples thereof include phenyl, tolyl, xylyl, naphthyl, anthryl and phenanthryl groups.

Examples of the heteroaryl group include heteroaryl groups containing an oxygen, nitrogen and/or sulfur atom in the ring thereof, and specific examples thereof include furyl, thienyl, imidazolyl, pyrazolyl, isoxazolyl, pyridyl, pyrazinyl, pyrimidinyl, pyridazinyl, indolyl, quinolyl, isoquinolyl and thiazolyl groups.

Examples of the polyethylenedioxy group include a tetraethylene glycol group.

Examples of the perfluoroalkyl group include linear or cyclic perfluoroalkyl groups having 1 to 20 carbon atoms. Specific examples thereof include perfluoroalkyl groups such as a trifluoromethyl group, pentafluoroethyl group, heptafluoropropyl group, nonafluorobutyl group or octafluorobutyl group. Among these, a trifluoromethyl group, nonafluorobutyl group or octafluorobutyl group is preferable.

Examples of the silyl group include trialkylsilyl groups and triarylsilyl groups. Specific examples thereof include silyl groups such as a trimethylsilyl group, triisopropylsilyl group, dimethylbutylsilyl group or triphenylsilyl group. Among these, a triisopropylsilyl group or dimethylbutylsilyl group is preferable.

Examples of the halogen include fluorine, chlorine and bromine. Fluorine is preferable.

Examples of the acyl group include alkylacyl groups and arylacyl groups. Specific examples thereof include acyl groups such as an acetyl group, propionyl group, pivaloyl group, hexanoyl group, 3,5-bis(*tert*-butyl)phenylacyl group or 3,5-bis(trifluoromethyl)phenylacyl group. Among these, a hexanoyl group or 3,5-bis(trifluoromethyl)phenylacyl group is preferable.

In addition, substituents on $Ar^1$ and $Ar^2$ may mutually bond to form a ring with adjacent atoms. For example, substituents on $Ar^1$ and $Ar^2$ may form a 5- to 8-membered cyclic hydrocarbon, condensed hydrocarbon ring or hetero ring, and may have 1 to 4 substituents such as an alkyl group (such as an alkyl group having 4 to 6 carbon atoms), halogen atom (such as fluorine, chlorine or bromine), carboxyl group, ester group, amide group or optionally protected hydroxyl group on the ring.

Although $Ar^1$ and $Ar^2$ may be the same, they are preferably different. A particularly preferable combination of $Ar^1$ and $Ar^2$ is that having a highly electron-accepting backbone such as thiazole, pyridine, pyrazine, pyrimidine, pyridazine, imidazole, oxazole or benzothiazole for $Ar^1$ and in which $Ar^1$ has a backbone having higher electron-accepting properties than $Ar^2$, and is particularly preferably a combination of thiazole for $Ar^1$ and thiophene for $Ar^2$.

<u>(Acceptor Site T: $R^1$ and $R^2$ in Chemical Formula (2a) or 2(b))</u>

In the above-mentioned chemical formula (2a) or (2b), $R^1$ and $R^2$ respectively and independently represent one type selected from the group consisting of carbon, nitrogen and phosphorous. At least one of these is nitrogen or

phosphorous having a coordination bond to boron.

Although $R^1$ and $R^2$ may be the same other than in the case of being carbon atoms, they are preferably different, and particularly preferably consist of the combination of carbon and nitrogen.

$R^1$ is nitrogen or phosphorous in formula (2b).

The dotted-line arrows can represent coordination bonds. In the case in which $R^1$ and $R^2$ are nitrogen or phosphorous, the dotted-line arrows represent coordination bonds, and in the case in which they are carbon, the dotted-line arrows represent ordinary covalent bonds.

<u>(Acceptor Site T: $R^3$ in Chemical Formula (2b))</u>

$R^3$ represents carbon and bonds to the anchor site A.

<u>(Acceptor Site T: X, $X^1$ and $X^2$ in Chemical Formula (2a) or (2b))</u>

In the above-mentioned chemical formula (2a) or (2b), X, $X^1$ and $X^2$ respectively and independently represent one type selected from the group consisting of a hydrogen, halogen, substituted or unsubstituted alkyl group, substituted or unsubstituted aryl group, substituted or unsubstituted heteroaryl group, substituted or unsubstituted alkenyl group, substituted or unsubstituted alkynyl group, substituted or unsubstituted amino group, substituted or unsubstituted alkoxy group, substituted or unsubstituted arylalkoxy group and hydroxyl group, or a substituted or unsubstituted 2,2'-biphenyl group or substituted or unsubstituted 2,2'-bithienyl group obtained by bonding of $X^1$ and $X^2$.

Examples of the halogen include fluorine, chlorine and bromine. Fluorine is preferable.

Examples of the alkyl group include linear, branched and cyclic alkyl groups having 1 to 20 carbon atoms. Specific examples thereof include alkyl groups having 1 to 20 carbon atoms such as a methyl, ethyl, *n*-propyl, isopropyl, n-butyl, isobutyl, *sec*-butyl, *tert*-butyl, pentyl, cyclopentyl, hexyl, cyclohexyl, isohexyl, 2-ethylhexyl, octyl, decyl, dodecyl or icosyl group. Among these, a hexyl group or 2-ethylhexyl group is preferable, and a hexyl group is particularly preferable. The alkyl group may have one or more (and preferably, 1 to 3) substituents selected from the group consisting of, for example, a halogen atom (such as fluorine, chlorine or bromine), carboxyl group, ester group, amide group and optionally protected hydroxyl group.

Examples of the aryl group and heteroaryl group include monocyclic aryl and heteroaryl groups as well as aryl and heteroaryl groups having two or more rings, and specific examples thereof include phenyl, naphthyl, anthryl, phenanthryl, thienyl, thiazolyl, furyl, pyridyl and oxazolyl groups. The aryl group and the heteroaryl group may each have one or more (and preferably, 1 to 5) substituents selected from the group consisting of, for example, an alkyl group (such as an alkyl group having 1 to 20 carbon atoms), perfluoroalkyl group, halogen atom (such as fluorine, chlorine or bromine), carboxyl group, ester group, amide group and optionally protected hydroxyl group. Specific examples include a 2,4,6-trimethylphenyl group (mesityl group), 4-perfluoroalkylphenyl group, 3,5-difluoroalkylphenyl group, 2,6-perfluoroalkylphenyl group, 2,6-dimethyl-4-perfluoroalkylphenyl group and 2,4,6-triperfluoroalkylphenyl group.

Examples of the alkenyl group include linear, branched and cyclic alkenyl groups having 2 to 20 carbon atoms, and specific examples thereof include vinyl, allyl, 1-butenyl, hexenyl, octenyl, decenyl and icosenyl groups. The alkenyl group may have one or more (and preferably, 1 to 5) substituents selected from the group consisting of an alkyl group (such as an alkyl group having 1 to 20 carbon atoms), aryl group, silyl group, cyano group, nitro group, perfluoroalkyl group, halogen atom (such as a fluorine, chlorine or bromine atom), carboxyl group, ester group, amide group and optionally protected hydroxyl group. Specific examples include an alkylethenyl group, arylethenyl group, silylethenyl group, arylethenyl group, cyanoethenyl group, nitroethenyl group, perfluoroalkylethenyl group, carboxyethenyl group and ester group-substituted ethenyl group. More specifically, examples include trimethylsilylethenyl, triisopropylsilylethenyl, methylbutylsilylethenyl and phenylethenyl groups. Among these, a 1-butenyl group, hexenyl group, octenyl group, trimethylsilylethenyl group, triisopropylsilylethenyl group, methylbutylsilylethenyl group or phenylethenyl group is preferable, and a phenylethenyl group is particularly preferable.

Examples of the alkynyl group include linear or branched alkynyl groups, and specific examples thereof include ethynyl, *n*-propargyl, 3,3-dimethyl-1-butynyl, hexynyl, octynyl, decynyl and icosynyl groups. The alkynyl group may also have one or more (and preferably, 1 to 5) substituents selected from the group consisting of an alkyl group (such as an alkyl group having 1 to 20 carbon atoms), aryl group, silyl group, cyano group, nitro group, perfluoroalkyl group, halogen atom (such as a fluorine, chlorine or bromine atom), carboxyl group, ester group, amide group and optionally protected hydroxyl group. Specific examples include an alkylethynyl group, silylethynyl group, arylethynyl group, cyanoethynyl group, nitroethynyl group, perfluoroalkylethynyl group, carboxyethynyl group and ester group-substituted ethynyl group. More specifically, examples include trimethylsilylethynyl, triisopropylsilylethynyl, methylbutylsilylethynyl and phenylethynyl groups. Among these, a 3,3-dimethyl-2-butynyl group, triisopropylsilylethynyl group or phenylethynyl group is preferable, and a phenylethynyl group is particularly preferable.

Examples of the alkoxy group include linear, branched and cyclic alkoxy groups having 1, to 20 carbon atoms.

Specific examples thereof include alkoxy groups having 1 to 20 carbon atoms such as a methyl, ethyl, *n*-propyl, isopropyl, *n*-butyl, isobutyl, *sec*-butyl, *tert*-butyl, pentyl, cyclopentyl, hexyl, cyclohexyl, isohexyl, 2-ethylhexyl, octyl, decyl, dodecyl or icosyl group, pinacolyl groups and 2,2-dimethyl-1,3-dioxy groups. Among these, a methyl group, hexyl group, 2-ethylhexyl group, pinacolyl group or 2,2-dimethyl-1,3-dioxy group is preferable, and a hexyl group or pinacolyl group is particularly preferable.

Examples of the aryl group in the arylalkoxy group include monocyclic aryl groups and aryl groups having two or more rings, and specific examples thereof include phenyl, tolyl, xylyl, naphthyl, anthryl and phenanthryl groups. The aryl group may also have one or more (and preferably, 1 to 3) substituents selected from the group consisting of, for example, an alkyl group (such as an alkyl group having 1 to 20 carbon atoms), halogen atom (such as a fluorine, chlorine or bromine atom), carboxyl group, ester group, amide group and optionally protected hydroxyl group.

Examples of substituents in the substituted pyrene group, substituted 2,2'-biphenyl group and substituted 2,2'-bithienyl group include an alkyl group, aryl group, heteroaryl group, perfluoroalkyl group and fluorine.

The definitions for the alkyl group, aryl group and heteroaryl group are the same as the definitions for those substituents in the above-mentioned $Ar^1$ and $Ar^2$.

The compound of the present invention represented by general formula (1) has the superior characteristic of allowing precise adjustment of the $\pi^*$ orbitals of a $\pi$-conjugated backbone by suitably selecting and changing $X^1$ and $X^2$. Namely, by selecting a suitable electron-withdrawing group for $X^1$ and $X^2$ without forcibly causing a decrease in LUMO level by introducing a strongly electron-withdrawing anchor, LUMO level can be lowered by a desired degree while maintaining expansion of the $\pi^*$ orbitals of $Ar^1$ and $Ar^2$.

Although $X^1$ and $X^2$ may be different, they are preferably the same, and are preferably tolyl groups, mesityl groups, 4-perfluoroalkylphenyl groups, 3,5-diperfluoroalkylphenyl groups, 2,6-perfluoroalkylphenyl groups, 2,6-dimethyl-4-perfluoroalkylphenyl groups or 2,4,6-triperfluoroalkylphenyl groups, and particularly preferably mesityl groups, 4-trifluoromethylphenyl groups, 3,5-bis(trifluoromethyl)phenyl groups, 2,6-dimethyl-4-nonafluorobutylphenyl groups or 2,3,4,5,6-pentafluorophenyl groups.

(Acceptor Site T: E in Chemical Formula (2a) or (2b))

In the above-mentioned chemical formula (2a) or (2b), E represents one type selected from the group consisting of a direct bond, -CR=CR-, =CR-, >C=O, =N-, -NR-, -O-, -S-, -PR-, =P- and -P(O)R-, wherein R independently represents at the time of each appearance at least one type selected from the group consisting of a hydrogen, alkyl group, alkoxy group, alkylthio group, aryl group, heteroaryl group, polyethylenedioxy group, perfluoroalkyl group, cyano group, amino group, silyl group, nitro group, halogen and acyl group. E is preferably a direct bond, =CH- or =N-.

Examples of the alkyl group, alkoxy group, alkylthio group, aryl group, heteroaryl group, polyethylenedioxy group, perfluoroalkyl group, cyano group, amino group, silyl group, nitro group, halogen and acyl group are the same as those listed as examples of the substituents on $Ar^1$ and $Ar^2$.

E is preferably a direct bond or the case in which conjugation of $\pi$ orbitals of $Ar^1$ and $Ar^2$ are expanded with C, N and P, and is particularly preferably a direct bond, =CR- or =N-.

In addition, adjacent backbones represented by the above-mentioned chemical formula (2a) or (2b) can be independently coupled directly in 2 to 10 units based on any coupling scheme selected from $Ar^1$-$Ar^2$, $Ar^1$-$Ar^1$ and $Ar^2$-$Ar^2$. Preferably, there are 1 to 3 units of the backbone represented by the above-mentioned chemical formula (2a), and particularly preferably 1 unit of the backbone represented by chemical formula (2a).

(Anchor Site A)

The anchor site A bound on the terminal $Ar^1$ of the above-mentioned acceptor site T in the above-mentioned chemical formula (2a) and bound to $R^3$ in chemical formula (2b) is a group capable of bonding to a semiconductor electrode, and examples thereof include one type selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group; and an alkoxy group, alkyl group, alkenyl group, alkynyl group, cycloalkyl group, aryl group, heteroaryl group and dioxocyclobutenyl group having at least one functional group selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group.

Examples of an alkyl group in the alkoxy group include linear, branched and cyclic alkyl groups having 1 to 6 carbon atoms. Specific examples thereof include alkyl groups having 1 to 6 carbon atoms such as a methyl, ethyl, *n*-propyl, isopropyl, *n*-butyl, isobutyl, sec-butyl, *tert*-butyl, pentyl, cyclopentyl, hexyl or cyclohexyl group. In addition, the alkyl group may also have a substituent such as a cyano group, nitro group, ester group, amide group or silyl group. Furthermore, the alkyl group may also have an ether bond in the manner of ethylene glycol. Among these, a methyl,

ethyl, n-propyl or hexyl group is preferable, and a methyl group is particularly preferable.

Examples of the alkyl group include linear, branched and cyclic alkyl groups having 1 to 6 carbon atoms, and specific examples thereof include alkyl groups having 1 to 6 carbon atoms such as a methyl, ethyl, n -propyl , isopropyl, *n*-butyl, isobutyl, sec-butyl, *tert*-butyl, pentyl, cyclopentyl, hexyl, cyclohexyl or isohexyl group. In addition, the alkyl group may also have a substituent such as a cyano group, nitro group, ester group, amide group or silyl group. Furthermore, the alkyl group may have an ether bond in the manner of ethylene glycol. Among these, a methyl, ethyl, *n*-propyl or hexyl group is preferable, and a methyl group is particularly preferable.

Examples of the alkenyl group include alkenyl groups having 2 to 8 carbon atoms, and specific examples thereof include alkenyl groups having 2 to 8 carbon atoms such as a vinyl group, allyl group, butadienyl group, hexatrienyl group, octatetraenyl group, cyclohexenyl group or cyclohexadienyl group. In addition, the alkenyl group may also have a substituent such as a cyano group, nitro group, ester group, amide group or silyl group. Among these, a vinyl group or butadienyl group is preferable, and a vinyl group is particularly preferable.

Examples of the alkynyl group include alkynyl groups having 2 to 6 carbon atoms, and specific examples thereof include an ethynyl group, propargyl group, butadiynyl group or hexatriynyl group. In addition, the alkynyl group may also have a substituent such as a cyano group, nitro group, ester group, amide group or silyl group. Among these, an ethynyl group or butadiynyl group is preferable, and an ethynyl group is particularly preferable.

Examples of the cycloalkyl group include a cyclopentyl group and cyclohexyl group.

Examples of the aryl group include monocyclic aryl groups and aryl groups having two or more rings, and specific examples thereof include phenyl, tolyl, styryl, xylyl, naphthyl, anthryl and phenanthryl groups. In addition, the aryl group may also have a substituent such as a cyano group, nitro group, ester group, amide group or silyl group. A phenyl group or styryl group is preferable.

Examples of the heteroaryl group include aryl groups having a single ring or two or more rings containing a nitrogen, oxygen, sulfur or phosphorous atom as a heteroatom, and specific examples thereof include pyridyl, furyl, thienyl, thienyl 1,1-dioxide, phorphoryl, phosphoryl 1-oxide, thiazole, oxazole, benzothiadiazole, imidazole, pyrazole, pyrimidine, pyridazine, quinoline, isoquinoline and pyrrolopyrrole-1,4-dione.

Examples of the silyl group include those having a substituent selected from the group consisting of a hydroxyl group, alkyl group, alkenyl group, alkynyl group, cycloalkyl group, aryl group, heteroaryl group, alkoxy group and aryloxy group, and specific examples thereof include a triethoxysilyl group, trihydroxysilyl group, ethoxydiethylsilyl group, diethoxyethylsilyl group, ethoxydiphenylsilyl group, propoxydipropylsilyl group, dipropoxypropylsilyl group and propoxydiphenylsilyl group.

Examples of the siloxy group include those having a substituent selected from the group consisting of a hydroxyl group, alkyl group, alkenyl group, alkynyl group, cycloalkyl group, aryl group, heteroaryl group, alkoxy group and aryloxy group, and specific examples thereof include a trihydroxysiloxy group, trimethylsiloxy group, triisopropylsiloxy group, triethoxysiloxy group, ethoxydiethylsiloxy group, diethoxyethylsiloxy group and ethoxydiphenylsiloxy group.

Examples of the phosphoryl group include groups represented by general formula $-P(=O)(R^p)_2$ (wherein $R^p$ independently represents a hydroxyl group, alkyl group, alkoxy group, phenyl group or phenoxy group), and specific examples thereof include a $-P(=O)(OH)_2$ group, hydroxy(methoxy)phorphoryl group, methoxy(phenyl)phosphoryl group, dimethoxyphosphoryl group, ethoxy(hydroxy)phosphoryl group, diethoxyphosphoryl group, ethoxy(phenyl)phosphoryl group, hydroxy(propoxy)phosphoryl group, dipropoxyphosphoryl group, phenyl(propoxy)phosphoryl group, hydroxy (phenoxy)phosphoryl group, diphenoxyphosphoryl group and phenoxy(phenyl)phosphoryl group.

The anchor site A can be suitably selected from the viewpoints of improving charge injection efficiency to a semiconductor electrode and improving chemical adsorption strength to an electrode.

The anchor site A is preferably a carboxyl group, cyanoacrylate group, methylene malonate group (2,2-dicarboxyvinyl group), silyl group (such as a trihydroxysilyl group or triethoxysilyl group), phosphoryl group (such as a $-P(=O)(OH)_2$ group), dioxocyclobutenyl group, boronic acid group or sulfonic acid group.

More preferable examples of the anchor site A include the groups indicated below.

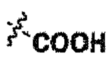
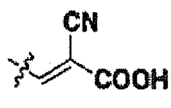
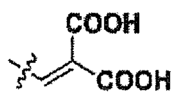

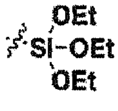
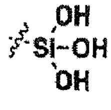

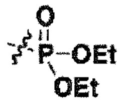

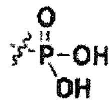

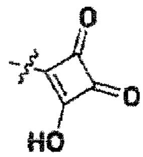

(Donor Site D)

In addition, the compound represented by the above-mentioned formula (1) can also contain a donor site D having an electron-donating backbone at the above-mentioned acceptor site T on the end on the opposite side from the anchor site A.

Examples of the above-mentioned donor site D include at least one type selected from the group consisting of a triarylamine derivative, carbazole derivative, substituted or unsubstituted aryl group, substituted or unsubstituted amino group, substituted or unsubstituted arylalkoxy group and substituted or unsubstituted arylthioalkoxy group.

Examples of the triarylamine derivative include triphenylamine, dinaphthylphenylamine, bis(4-alkylphenyl)phenylamine, bis(4-alkoxyphenyl)phenylamine, bis(9,9-dimethylfluore-2-yl)phenylamine, diphenylthienylamine, bis(4-alkylphenyl)thienylamine, bis(4-alkoxyphenyl)thienylamine and bis(9,9-dimethylfluore-2-yl)thienylamine, or more preferably, bis(4-alkylphenyl)phenylamine or bis(4-alkoxyphenyl)phenylamine.

Examples of the carbazole derivative include 9-alkylcarbazoles and 9-arylcarbazoles. Specific examples thereof include 9-ethylcarbazole, 9-phenylcarbazole and 9-fluorenylcarbazole, or more preferably, 9-ethylcarbazole.

Examples of the substituted or unsubstituted aryl group include a phenyl group, 4-alkoxyphenyl group, 4-tetraethylene glycoxyphenyl group, 3,4,5-trialkoxyphenyl group, dimethylaminophenyl group, diethylaminophenyl group, pyrrolodylphenyl group, thienyl group, alkylthienyl group, alkoxythienyl group, ethylenedioxythienyl group, phenothiazinyl group and thianthrenyl group. Examples of alkyl groups of the alkylthienyl group and alkoxy groups of the alkoxythienyl group are the same as the alkyl groups and alkoxy groups listed as examples of substituents on the above-mentioned $Ar^1$ and $Ar^2$. In addition, a plurality of these aryl groups may be linked. A diethylaminophenyl group, 3,4,5-trialkoxyphenyl group or ethylenedioxythienyl group is preferable.

Examples of the substituted or unsubstituted amino group include a dimethylamino group, diethylamino group, dibutylamino group and pyrrolidyl group. A pyrrolidyl group is preferable.

Examples of the substituted or unsubstituted arylalkoxy group include aryloxy groups having for the aryl group a phenyl group, 4-alkoxyphenyl group, 4-hexyloxyphenyloxy group, 4-tetraethylene glycoxyphenyl group, 3,4,5-trialkoxyphenyl group, dimethylaminophenyl group, diethylaminophenyl group or pyrrolidylphenyl group. A 4-hexyloxyphenyloxy group is preferable.

Examples of the substituted or unsubstituted arylthioalkoxy group include arylthio groups having for the aryl group a phenyl group, 4-alkoxyphenyl group, 4-hexyloxyphenylthio group, 4-tetraethylene glycoxyphenyl group, 3,4,5-trialkoxyphenyl group, dimethylaminophenyl group, diethylaminophenyl group or pyrrolidylphenyl group. A 4-hexyloxyphenylthio group is preferable.

The donor site D can be suitably selected from the viewpoints of light absorption efficiency, and inhibition of charge separation and charge reconsolidation.

A combination of units is preferably selected so that each unit has the HOMO at the donor site D by selecting a backbone having the highest electron-donating properties among each unit of the molecule for the donor site D. A bis(4-hexylphenyl)aminophenyl group is selected particularly preferably for molecules having a substituted or unsubstituted thiophene.

(Spacer Site Q)

Moreover, the compound represented by the above-mentioned formula (1) can also contain a spacer site Q having a π-conjugated backbone between the acceptor site T and the above-mentioned donor site D. The π conjugation can be expanded by coupling a π-conjugated backbone to the acceptor site T having an electron-accepting backbone resulting from intramolecular coordination bond, thereby demonstrating a more prominent long wavelength shift. Namely, light absorbance efficiency can be expected to be improved when using as a dye-sensitized material for a solar cell.

Examples of the above-mentioned spacer site Q include at least one type selected from the group consisting

of an alkenyl group, alkynyl group, substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted benzothiazole, substituted or unsubstituted benzo(bis)thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline.

Examples of the alkenyl group include alkenyl groups having 2 to 8 carbon atoms, and examples thereof include alkenyl groups having 2 to 8 carbon atoms such as a vinyl group, allyl group, butadienyl group, hexatrienyl group, octatetraenyl group, cyclohexenyl group or cyclohexadienyl group. A vinyl group or butadienyl group is preferable, and a vinyl group is particularly preferable.

Examples of the alkynyl group include alkynyl groups having 2 to 6 carbon atoms, and specific examples thereof include an ethynyl group, propargyl group, butadiynyl group or hexatriynyl group. An ethynyl group or butadiynyl group is preferable, and an ethynyl group is particularly preferable.

Examples of the heterole, heterole oxide, benzoheterole, benzoheterole oxide, dibenzoheterole, dibenzoheterole oxide, fluorene derivative, dithienoheterole, dithienoheterole oxide, thienoheterole, thienoheterole oxide, benzodiheterole, benzodiheterole oxide and acene are the same as those of the aforementioned $Ar^1$ and $Ar^2$.

In addition, groups able to be substituted on the above-mentioned Q are the same as groups able to be substituted on the above-mentioned $Ar^1$ and $Ar^2$.

In addition, the above-mentioned spacer site Q may also be that in which two or more groups independently selected from the above-mentioned choices are bonded.

Although one or more of the same or different backbones described above can be selected for the spacer site Q, cases in which a plurality thereof is combined are preferable. Examples thereof include 3,3'-dihexylbithiophene, 3,3', 3''-trihexylterthiophene, 3-hexylbithiophene, 3,3'-dihexyloxybithiophene, 3,3',3''-trihexyloxyterthiophene, 3-hexyloxybithiophene and 3,4-ethylenedioxy-3'-hexyl-2,2'-bithiophene. Cases in which the backbone on the side of the donor site (D) has higher electron-donating properties than the backbone on the side of the acceptor site (T) are more preferable, and examples thereof include 3-hexylbithiophene and 3,4-ethylenedioxy-3'-hexyl-2,2'-bithiophene.

The spacer site Q is able to bond on the terminal $Ar^2$ in the above-mentioned general formula (1).

In addition, substituents on the above-mentioned spacer site Q may mutually bond to form a ring with adjacent atoms. For example, substituents on Q may form a 5- to 8-membered cyclic hydrocarbon, condensed hydrocarbon ring or hetero ring, and may have 1 to 4 substituents such as an alkyl group (such as an alkyl group having 1 to 4 carbon atoms), halogen atom (such as fluorine, chlorine or bromine), carboxyl group, ester group, amide group or optionally protected hydroxyl group on the ring.

<u>Compound Production Method</u>

The compound of the present invention can be produced according to the method indicated below or method conforming thereto.

The compound represented by the above-mentioned general formula (1) can be produced by, for example, introducing the anchor site A onto the end of the acceptor site T.

The compound represented by chemical formula (2a) of the acceptor site T can be produced according to, for example, the method indicated below.

(1) $Ar^1$ and $Ar^2$ are coupled by a cross-coupling reaction to synthesize a heteroatom-containing $\pi$-conjugated coupling compound.
(2) Continuing, a boron substituent is introduced by going through metalation of a heteroatom-containing ring.
Alternatively, the compound can be produced by carrying out (3) below instead of the above-mentioned (2).
(3) The heteroatom-containing $\pi$-conjugated coupling compound obtained according to (1) is converted to a pinacol form or methoxy form as a substituent on boron according to the method indicated in (2), and a Grignard reagent and the like of the $X^1$ and $X^2$ desired to be introduced thereto is allowed to react by using resulting pinacol form or methoxy form as a synthesis intermediate.

Various $X^1$ and $X^2$ can be easily introduced in the reaction of (3).

In addition, although the acceptor site T, obtained by directly coupling 2 to 10 units of adjacent backbones

represented by the above-mentioned chemical formula (2a), can be produced using a method consisting of synthesizing a precursor in which $Ar^1$ and $Ar^2$ backbones are preliminarily coupled by cross-coupling and the like followed by introducing a boron substituent, it can also be produced using any of the following methods of (a) to (c) by utilizing a synthesis intermediate represented by chemical formula (3a) indicated below.

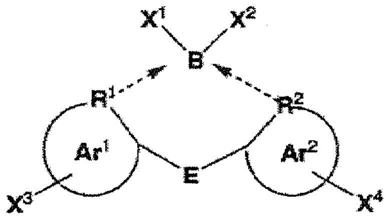
(3 a)

(a) Method consisting of cross-coupling a compound in which $X^3$ is a halogen atom and $X^4$ is a hydrogen atom in the compound represented by chemical formula (3a) with a compound in which $X^3$ is a halogen atom and $X^4$ is a metalated group such as a trialkylstannyl group using a palladium catalyst.
(b) Method consisting of oxidatively homo-coupling compounds in which $X^3$ is a hydrogen atom and $X^4$ is a lithium ion in the compound represented by general formula (3a) using a copper complex.
(c) Method consisting of oxidatively homo-coupling compounds in which $X^3$ is a halogen atom and $X^4$ is a hydrogen atom in the compound represented by general formula (3a) using a nickel complex.

After having synthesized the acceptor site T as described above, subjecting at least one hydrogen atom on the terminal $Ar^1$ in chemical formula (2a) or a hydrogen atom on $R^3$ in chemical formula (2b) to 1),2) or 3), obtain a compound represented by general formula (1) having an anchor site A by substituting with a group capable of bonding to a semiconductor electrode as previously described. That is,

1) carrying out metalation and then a nucleophilic substitution reaction,
2) carrying out metalation and then a cross-coupling reaction using Pd and the like, and
3) carrying out halogenation and then a cross-coupling reaction and the like using Pd and the like.

In addition, in the case in which the acceptor site T in the above-mentioned general formula (1) contains a donor site D having an electron-donating backbone, the donor site D and $Ar^2$ are coupled by a cross-coupling reaction using Pd and the like or by a nucleophilic substitution reaction mediated by metalation prior to introducing the above-mentioned anchor site A.

Moreover, in the case of containing a spacer site Q between the acceptor site T and the donor site D in the above-mentioned general formula (1), after having first coupled the donor site D and the spacer site Q using a cross-coupling reaction using Pd and the like or a nucleophilic substitution reaction mediated by metalation, the acceptor site T is introduced into the spacer site Q of the resulting conjugant using a cross-coupling reaction using Pd and the like, and finally the anchor site A is introduced onto the end of the acceptor site T.

Alternatively, the anchor site A may be preliminarily introduced into the acceptor site, followed by carrying out coupling with the donor site D and the like.

A compound represented by chemical formula (2b) of the acceptor site T can be produced according to, for example, a method that conforms to the production method of the compound represented by chemical formula (2a).

These reaction conditions used in the production method of the compound of the present invention may be suitably determined based on common general technical knowledge of a person with ordinary skill in the art.

2. Dye-Sensitized Solar Cell

The present invention provides a photovoltaic method comprising exposing to light the compound previously described in detail. Namely, the compound previously described in detail can be used as a dye for a dye-sensitized solar cell in the generation of solar power.

The dye is contained along with a metal oxide in a light-absorbing layer in a dye-sensitized solar cell comprising: a first electrode, the light-absorbing layer formed on one side of the first electrode, a second electrode arranged in opposition to the first electrode on which the light-absorbing layer is formed, and a charge transport material positioned between the first electrode and the second electrode.

The following provides an exemplary explanation of a dye-sensitized solar cell that uses the compound represented by the above-mentioned general formula (1) of the present invention as a dye for a dye-sensitized solar cell.

First Electrode

An electrically conductive substrate is used for the first electrode, because it is a support for the light-absorbing layer and has the function of extracting current from the light-absorbing layer. The first electrode is composed of a transparent conductive layer having translucency that allows the transmission of light imparted for photoelectric conversion.

Examples of the transparent conductive layer include a tin-doped indium oxide (ITO) film, impurity-doped indium oxide ($In_2O_3$) film, impurity-doped zinc oxide (ZnO) film, fluorine-doped tin dioxide film, and laminated films obtained by laminating these films.

The transparent conductive layer is obtained by using a known deposition method corresponding to the material to be molded.

In addition, the transparent conductive layer may be coated with a translucent covering as necessary in order to protect it from the outside.

Examples of the translucent covering include resin sheets made of fluororesin, polyvinyl chloride resin or polyimide and the like, inorganic sheets such as white-board glass or soda glass, and hybrid sheets obtained by combining these materials.

Light-Absorbing Layer

The light-absorbing layer contains a metal oxide and a dye composed of the compound represented by the above-mentioned general formula (1) of the present application. The dye is preferably adsorbed onto the surface of the metal oxide. Photoelectric conversion is able to be carried out as a result of the dye absorbing light and the excited electrons being transferred to the metal oxide.

Examples of the metal oxide include n-type semiconductors selected from the group consisting of titanium oxide, tin oxide and zinc oxide. Photoelectric conversion efficiency can be enhanced by using an oxide having semiconductivity. Titanium oxide is particularly preferable from the viewpoint of having fewer lattice defects in comparison with other metal oxides.

In addition, the above-mentioned metal oxide is preferably porous in order to adsorb as much dye as possible.

The dye of the invention of the present application can be adsorbed onto the metal oxide using a method indicated below. For example, a method can be used in which a conductive substrate on which the metal oxide is formed is immersed in a solution in which the dye has been dissolved, or a method can be used in which, after having sealed the periphery of a conductive substrate on which the metal oxide has been formed with a sealant and the like, a solution in which the dye has been dissolved is injected through sealant injection openings, and the solution is allowed to circulate in the sealed interior to allow the dye to be adsorbed onto the metal oxide. There are no particular limitations on the temperature and pressure used in the adsorption method, and it can be carried out at normal temperature and pressure. In addition, there are also no particular limitations on the solvent provided it dissolves the dye, and a known solvent can be used, such as alcohols, ketones, ethers or nitrogen-containing compounds.

Charge Transport Material

The charge transport material has the function of transporting charge. Examples of charge transport materials that can be used include conductors, semiconductors and electrolytes. The charge transport material functions as a positive hole transport material that accepts positive holes from the dye in the light-absorbing layer and transfers them.

Examples of the conductors and semiconductors include compound semiconductors containing monovalent copper such as CuI, $CuInSe_2$ or CuS, as well as GaP, NiO, CoO, FeO, $Bi_2O_3$, $MoO_2$ and $Cr_2O_3$. A semiconductor containing monovalent copper is preferable, and CuI is more preferable.

In addition, examples of the electrolytes include liquid electrolytes, solid electrolytes, gel electrolytes and molten salts.

Examples of liquid electrolytes that can be used include those obtained by dissolving a quaternary ammonium salt or lithium salt in a solvent such as propylene carbonate or acetonitrile, and those obtained by dissolving tetrapropylammonium iodide, lithium iodide or iodine in a solvent such as methoxypropionitrile.

Examples of solid electrolytes include those having a sulfone imidazolium salt, tetracyanoquinodimethane salt or dicyanoquinodiimine salt in a polymer chain such as that of polyethylene oxide or polyethylene.

Examples of gel electrolytes include those polymerized by mixing a host-polymer such as polyethylene oxide, polyacrylonitrile, polyvinylidene fluoride, polyvinyl alcohol, polyacrylic acid or polyacrylamide with acetonitrile, ethylene

carbonate, propylene carbonate or a mixture thereof.

Molten salts of iodides can be used for the molten salts. Examples thereof include iodides such as imidazolium salts, quaternary ammonium salts, isoxazolidinium salts, isothiazolidinium salts, pyrazolidinium salts, pyrrolidinium salts or pyridinium salts.

Second Electrode

The second electrode is arranged in opposition to the first electrode, and since it has electrical conductivity allowing the exchange of charge with the above-mentioned charge transport material, an electrically conductive substrate is used.

Examples of the electrically conductive substrate include a metal substrate, a substrate containing an electrically conductive member, and an insulating substrate having an electrically conductive film formed on the surface thereof.

A known material used in the art can be used for the metal substrate, and examples thereof include metals such as platinum, titanium, stainless steel, aluminum, silver or nickel and alloys thereof.

Examples of the substrate in a substrate containing an electrically conductive member include an insulating material such as an organic resin material or inorganic material. Specific examples thereof include organic materials such as polyethylene terephthalate, polyethylene naphthalate, polyimide or polycarbonate, and inorganic materials such as blue-board glass, soda glass, borosilicate glass or ceramics.

In addition, examples of electrically conductive members contained in the substrate include fine particles and fine lines of metal composed of materials of the above-mentioned metal substrates, and fine particles and fine lines of carbon.

Examples of insulating substrates having the electrically conductive film formed on the surface thereof include those obtained by forming an electrically conductive film on insulating materials similar to those described above by CVC and the like.

Examples of the electrically conductive film include metal thin films, transparent electrically conductive films, electrically conductive films composed of aluminum-doped zinc oxide, and laminated electrically conductive film layers obtained by interposing an ITO layer between a pair of titanium layers.

Examples of the metal thin films include those composed of titanium, stainless steel, aluminum, silver, copper or nickel.

Examples of the transparent electrically conductive films include ITO (tin-doped indium oxide) and FTO (fluorine-doped tin oxide).

EXAMPLES

Although the following provides a more detailed explanation of the present invention by indicating examples and the like thereof, the present invention is not limited thereto.

The following indicates methods used to measure the various performance values indicated below.

<$^1$H-NMR and $^{13}$C-NMR>

$^1$H-NMR and $^{13}$C-NMR spectra were measured using the Mercury 300 manufactured by Varian Corp.

<Elementary Analysis>

Measurements were carried out using the Micro Corder JM10 manufactured by J-Science Lab Co., Ltd.

Synthesis Example 1 (Synthesis of Acceptor Site T)

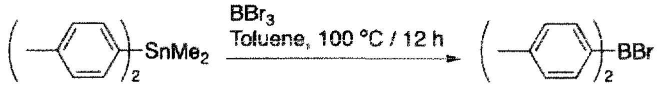


1 2

$BBr_3$ (500 μL, 5.3 mmol) was dropped into a toluene (2.5 mL) solution of Compound 1 (1.73 g, 5.3 mmol) at room temperature followed by sealing and stirring for 12 hours at 100°C. After cooling to 50°C, pressure was reduced and the solvent was distilled off. The temperature was gradually raised to 100°C under reduced pressure to remove the by-product tin compound. After cooling to room temperature, the resulting Compound 2 as a pale yellow solid was used

as is in the next reaction.

$^1$H-NMR (270 MHz, $CDCl_3$) δ8.08 (d. $J_{HH}$=7.8 Hz, 4H), 7.10 (d, $J_{HH}$=7.8 Hz, 4H), 2.15 (s, 6H)

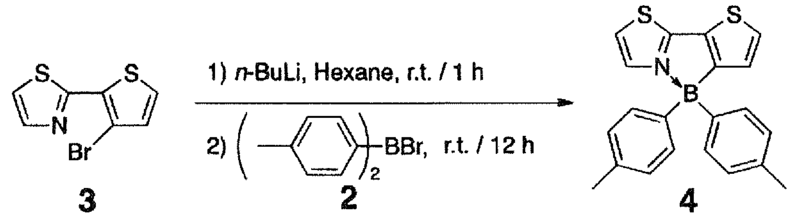


A hexane solution of n-BuLi (1.60M, 3.6mL, 5.8mmol) was dropped into a hexane (60 mL) solution of Compound 3 (1.45 g, 5.8 mmol). After stirring for 1 hour, the reaction mixture was dropped into a hexane (60 mL) solution of Compound 2 followed by stirring for 12 hours at room temperature. After adding water, the organic layer was separated and the aqueous layer was washed with dichloromethane. The organic layer was dried over anhydrous $Na_2SO_4$ and filtered following by distilling off the solvent under reduced pressure. The mixture was then purified by silica gel column chromatography (developing solvent: hexane:dichloromethane = 1:1) and recrystallization (dichloromethane) to obtain Compound 4 (1.46 g, 4.1 mmol) in a yield of 77% as a pale yellow solid.

$^1$H-NMR (270 MHz, $CDCl_3$) δ7.78 (d, $J_{HH}$=3.6 Hz, 1H), 7.60 (d, $J_{HH}$=4.0 Hz, 1H), 7.33 (d, $J_{HH}$=4.0 Hz, 1H), 7.21 (d, $J_{HH}$=3.6 Hz, 1H), 7.15 (d, $J_{HH}$=7.9 Hz, 4H), 7.02 (d, $J_{HH}$=7.9 Hz, 4H), 2.28 (s, 6H)

Synthesis Example 2 (Synthesis of Acceptor Site T)

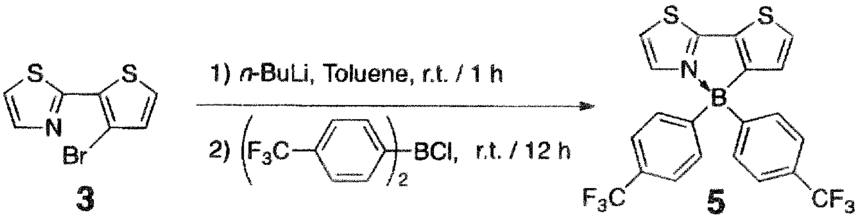


A hexane solution of *n*-BuLi (1.60M, 1.3mL, 2.0 mmol) was dropped into a toluene (4 mL) solution of Compound 3 (887 mg, 2.0 mmol) at room temperature. After stirring for 1 hour, the reaction mixture was dropped into a toluene (4 mL) solution of chlorobis(4-(trifluoromethyl)phenyl)borane at room temperature followed by stirring for 12 hours. The reaction mixture was passed through Celite and the solvent was distilled off under reduced pressure. The solvent was distilled off by passing through a silica gel short column (developing solvent: toluene). The mixture was then purified by chloroform GPC to obtain Compound 5 (414 mg, 0.89 mmol) in a yield of 44% as a pale yellow solid.

$^1$H-NMR (400 MHz, $CDCl_3$) δ7.75 (d, $J_{HH}$=3.6 Hz, 1H), 7.69 (d, $J_{HH}$=4.4 Hz, 1H), 7.44 (d, $J_{HH}$=7.6 Hz, 4H), 7.32 (d, $J_{HH}$=4.4 Hz, 1H), 7.31 (d, $J_{HH}$=3.6 Hz, 1H), 7.30 (d, $J_{HH}$=7.6 Hz, 4H)

Synthesis Example 3 (Synthesis of Acceptor Site T)

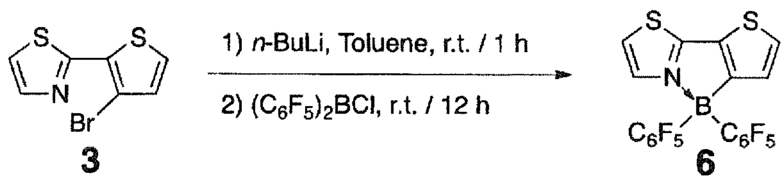


A hexane solution of n-BuLi (1. 60 M, 2.5 ml, 4.0 mmol) was dropped into a toluene (4 mL) solution of Compound 3 (989 mg, 4.0 mmol) at room temperature. After stirring for 1 hour, the reaction mixture was dropped into a toluene (2 mL) solution of chlorobis(pentafluorophenyl)borane at room temperature followed by stirring for 12 hours. After adding a saturated aqueous $NHCl_4$ solution, the organic layer was separated and the aqueous layer was extracted with toluene.

The organic layer was dried over anhydrous $Na_2SO_4$ and filtered followed by distilling off the solvent under reduced pressure. The mixture was then purified by silica gel column chromatography (developing solvent: hexane:toluene = 1: 1) to obtain Compound 6 (438 mg, 0.86 mmol) in a yield of 21% as a pale yellow solid.

$^1$H-NMR (400 MHz, $CDCl_3$) δ7.99 (d, $J_{HH}$=3.6 Hz, 1H), 7.64 (d, $J_{HH}$=4.8 Hz, 1H), 7.41 (d, $J_{HH}$=4.8 Hz, 1H), 7.24 (d, $J_{HH}$=3.6 Hz, 1H)

Synthesis Example 4 (Synthesis of Acceptor Site T)

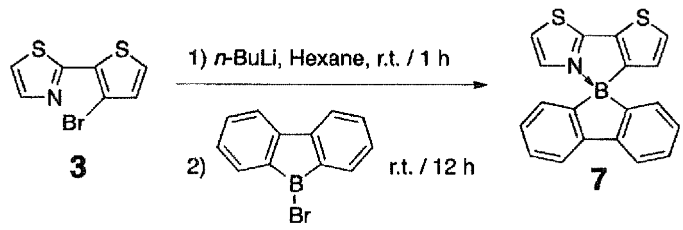


3 7

A hexane solution of n-BuLi (1.60 M, 0.7 mL, 1.1 mmol) was dropped into a hexane (10 mL) solution of Compound 3 (251 mg, 1.0 mmol) at room temperature. After stirring for 1 hour, the reaction mixture was dropped into a toluene (5 mL) solution of 5-bromo-5H-dibenzo[b,d]borole at room temperature followed by stirring for 12 hours. After distilling off the solvent under reduced pressure, dichloromethane was added followed by passing through Celite. After distilling off the solvent under reduced pressure and passing through a silica gel short column (developing solvent: toluene), the mixture was purified by chloroform GPC to obtain Compound 7 (152 mg, 0.46 mmol) in a yield of 45% as a pale yellow solid.

$^1$H-NMR (270 MHz, $CDCl_3$) δ7.73 (d, $J_{HH}$=5.6 Hz, 2H), 7.58 (d, $J_{HH}$=3.3 Hz, 1H), 7.27 (t, $J_{HH}$=5.6 Hz, 2H), 7.14 (d, $J_{HH}$=2.7 7 Hz, 1H), 7.07 (d, $J_{HH}$=2.7 Hz, 1H), 7.02 (d, $J_{HH}$=5.6 Hz, 2H), 6.98 (d, $J_{HH}$=3.3 Hz, 1H), 6.90 (d, $J_{HH}$=5.6 Hz, 2H)

Synthesis Example 5 (Synthesis of Acceptor Site T)

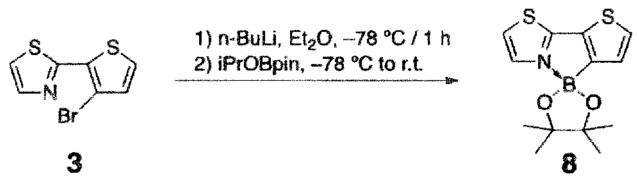


3 8

A hexane solution of n-BuLi (1.60 M, 625 μL, 1.0 mmol) was dropped into an $Et_2O$ (10 mL) solution of Compound 3 (247 mg, 1.0 mmol) after having cooled to -78°C. After stirring for 1 hour at -78°C, i-PrOBpin (224 μL, 1.1 mmol) was added followed by slowly raising the temperature to room temperature. After adding a saturated aqueous $NH_4Cl$ solution, the organic layer was separated and the aqueous layer was extracted with $Et_2O$. The organic layer was dried over anhydrous $Na_2SO_4$ and filtered followed by distilling off the solvent under reduced pressure. The precipitated pale yellow solid was washed with a small amount of hexane to obtain Compound 8 (250 mg, 0.85 mmol) in a yield of 78%.

$^1$H-NMR (300 MHz, $CDCl_3$) δ7.78 (d, $J_{HH}$=3.3 Hz, 1H), 7.35 (s, 2H), 7.34 (d, $J_{HH}$=3.3 Hz, 1H), 1.38 (s, 12H)

Synthesis Example 6 (Synthesis of Acceptor Site T)

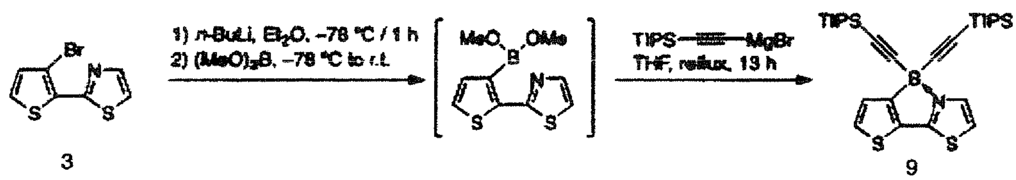


3 9

A hexane solution of n-BuLi (1.60 M, 500 μL, 0.80 mmol) was dropped into an $Et_2O$ (5 mL) solution of Compound 3 (197 mg, 0.80 mmol) after having cooled to -78°C. After stirring for 1 hour at -78°C, trimethyl borate (89 μL, 0.80 mmol) was added followed by slowly raising the temperature of the reaction mixture to room temperature. After distilling off the solvent, 5 mL of a THF solution of triisopropylsilylethynyl magnesium bromide (obtained by adding 2-bromoethynyltriisopropylsilane (1.25 g, 4.8 mmol) and THF to magnesium tuning (139 mg, 5. 7 mmol), prepared at the time of use) were added followed by refluxing for 13 hours. After adding water (5 mL), the organic layer was separated and the aqueous layer was extracted three times with dichloromethane. The organic layer was dried over anhydrous $Na_2SO_4$ and filtered followed by distilling off the solvent under reduced pressure. The mixture was then purified by toluene GPC to obtain Compound 9 (25.6 mg, 47.4 μmol) in a yield of 6% as a pale yellow solid.

$^1$H-NMR (300 MHz, benzene-$d_6$) δ7.45 (d, $J_{HH}$=3.3 Hz, 1H), 7.30 (d, $J_{HH}$=4.8 Hz, 1H), 6.89 (d, $J_{HH}$=4.8 Hz, 1H), 5.66 (d, $J_{HH}$=3.6 Hz, 1H), 1.23 (d, $J_{HH}$=6.3 Hz, 36H), 1.16 (d, $J_{HH}$=6.3 Hz, 6H)

Synthesis Example 7 (Synthesis of Acceptor Site T)

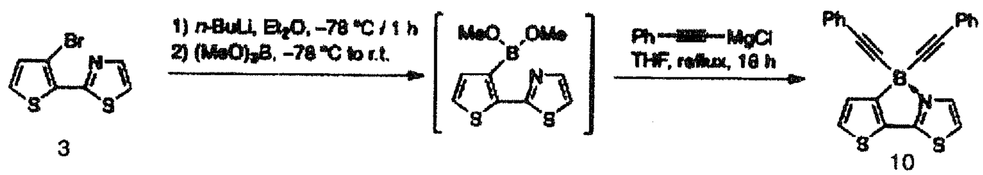


3

10

A hexane solution of n-BuLi (1.60 M, 507 μL, 0.81 mmol) was dropped into an $Et_2O$ (5 mL) solution of Compound 3 (200 mg, 0.81 mmol) after having cooled to -78°C. After stirring for 1 hour at -78°C, trimethyl borate (91 μL, 0.81 mmol) was added followed by slowing raising the temperature of the reaction mixture to room temperature. After distilling off the solvent, 5 mL of a THF solution of phenylethynyl magnesium chloride (obtained by adding a THF solution of t-butyl magnesium chloride (1.7M, 1.19mL, 2.03 mmol) to a THF solution of phenylacetylene (223 μL, 2.03 mmol), prepared at the time of use) were added followed by refluxing for 16 hours. After adding water (5 mL), the organic layer was separated and the aqueous layer was washed three times with dichloromethane. The organic layer was dried over anhydrous $Na_2SO_4$ and filtered followed by distilling off the solvent under reduced pressure. The crude product was re-dissolved in dichloromethane and filtered by passing through a silica gel short column. After distilling off the solvent, the solid was washed with hexane to obtain Compound 10 (64.1 mg, 0.169 mmol) in a yield of 21% as a pale yellow solid.

$^1$H-NMR (300 MHz, $CDCl_3$) δ8.02 (d, $J_{HH}$=3.6 Hz, 1H), 7.66 (d, $J_{HH}$=4.8 Hz, 1H), 7.46 (d, $J_{HH}$=4.8 Hz, 1H), 7.43-7.40 (m, 4H), 7.28 (d, $J_{HH}$=3.6 Hz, 1H), 7.22-7.20 (m, overlapped, 6H)

Synthesis Example 8 (Synthesis of Acceptor Site T)

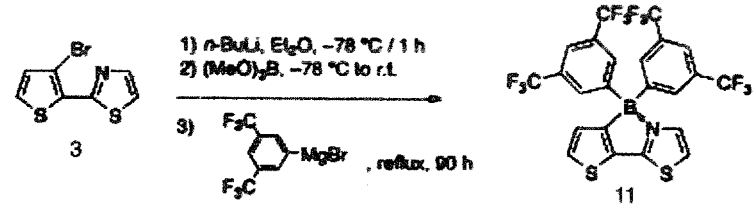


3

11

A hexane solution of n-BuLi (1.60 M, 1.25 mL, 2.00 mmol) was dropped into an $Et_2O$ (10 mL) solution of Compound 3 (493 mg, 2.00 mmol) after having cooled to -78°C. After stirring for 1 hour at -78°C, trimethyl borate (223 μL, 2.00 mmol) was added followed by slowly raising the temperature of the reaction mixture to room temperature. 10 mL of an $Et_2O$ solution of 3,5-bis(trifluoromethyl)phenyl magnesium bromide (obtained by adding 3,5-bis(trifluoromethyl) bromobenzene (1.72 mL, 10.0 mmol) and $Et_2O$ to magnesium tuning (245 mg, 10.1 mmol), prepared at the time of use) were added to this solution followed by refluxing the mixture for 90 hours. After adding saturated aqueous ammonium chloride solution, the organic layer was separated and the aqueous layer was extracted three times with dichloromethane. The organic layer was dried over anhydrous $Mg_2SO_4$ and filtered followed by distilling off the solvent under reduced pressure. The mixture was then purified by silica gel column chromatography (developing solvent: hexane:dichloromethane = 2:1) to obtain Compound 11 (944 mg, 1.57 mmol) in a yield of 78% as a pale yellow solid (melting point: 170-171°C).

$^1$H-NMR (600 MHz, $CDCl_3$) δ7.77 (d, $J_{HH}$=4.6 Hz, 1H), 7.72 (d, $J_{HH}$=3.7 Hz, 1H), 7.71 (s, 2H), 7.57 (s, 4H), 7.41 (d, $J_{HH}$=3.7 Hz, 1H), 7.31 (d, $J_{HH}$=4.6 Hz, 1H)

$^{13}$C-NMR (150 MHz, $CDCl_3$) δ176.58, 168.48, 149.57, 135.87, 134.01, 132.26, 132.23 (q, $J_{CF}$=3.9 Hz), 130.57

(q, $J_{CF}$=32.3 Hz), 128.84, 123.80 (q, $J_{CF}$=272.7 Hz), 120.54 (sept, $J_{CF}$=3.9 Hz) 119.02

$^{11}$B-NMR (192 MHz, $CDCl_3$) δ0.30

$^{19}$F-NMR (565 MHz, $CDCl_3$) δ-63.17

Anal. Calcd. for $C_{23}H_{10}BF_{12}NS_2$: C: 45.79, H: 1.67, N: 2.32, Found: C: 46.09, H: 1.62, N: 2.47

Synthesis Example 9 (Synthesis of Acceptor Site T)

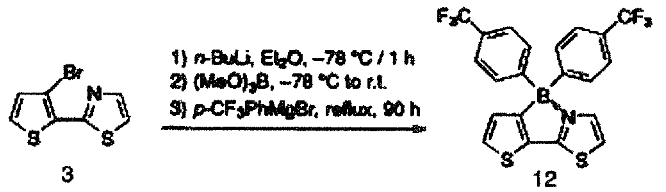


3 12

A hexane solution of n-BuLi (1.60 M, 1.91 mL, 3.05 mmol) was dropped into an $Et_2O$ (31 mL) solution of Compound 3 (750 mg, 3.05 mmol) after having cooled to -78°C. After stirring for 1 hour at -78°C, trimethyl borate (340 μL, 3.05 mmol) was added followed by slowly raising the temperature of the reaction mixture to room temperature. 30 mL of an $Et_2O$ solution of *p*-trifluoromethylphenyl magnesium bromide (obtained by adding *p*-trifluoromethylbromobenzene (2.14 mL, 15.3 mmol) and $Et_2O$ to magnesium tuning (233 mg, 15.3 mmol), prepared at the time of use) were added to this solution followed by refluxing the mixture for 90 hours. After adding saturated aqueous ammonium chloride solution, the organic layer was separated and the aqueous layer was extracted three times with dichloromethane. The organic layer was dried over anhydrous $Mg_2SO_4$ and filtered followed by distilling off the solvent under reduced pressure. The mixture was then purified by silica gel column chromatography (developing solvent: hexane:dichloromethane = 3: 1) to obtain Compound 12 (982 mg, 2.10 mmol) in a yield of 69% as a pale yellow solid (melting point: 174-175°C).

$^{1}$H-NMR (600 MHz, $CDCl_3$) δ7.76 (d, $J_{HH}$=3.6 Hz, 1H), 7.69 (d, $J_{HH}$=4.6 Hz, 1H), 7.46 (d, $J_{HH}$=7.7 Hz. 4H), 7.33 (d, $J_{HH}$=4.6 Hz, 1H), 7.32 (d, $J_{HH}$=7.7 Hz, 4H), 7.30 (d, $J_{HH}$=3.6 Hz, 1H)

$^{13}$C-NMR (150 MHz, $CDCl_3$) δ178.56, 167.73, 152.33, 134.73, 134.62, 132.79, 131.69, 129.18, 128.19 (q, $J_{CF}$=32.1 Hz), 124.64 (q, $J_{CF}$=271.8 Hz), 124.18 (q, $J_{CF}$=3.8 Hz), 117.96

$^{11}$B-NMR (192 MHz, $CDCl_3$) δ0-99

$^{19}$F-NMR (565 MHz, $CDCl_3$) δ-62.83

Anal. Calcd. for $C_{23}H_{10}BF_{12}NS_2$: C: 53.98, H: 2.59, N: 3.00, Found: C: 54.18, H: 2.53, N: 3.13

Example 1 (Synthesis of Compound)

<u>(1) Preparation of Spacer Site Q and Donor Site D</u>

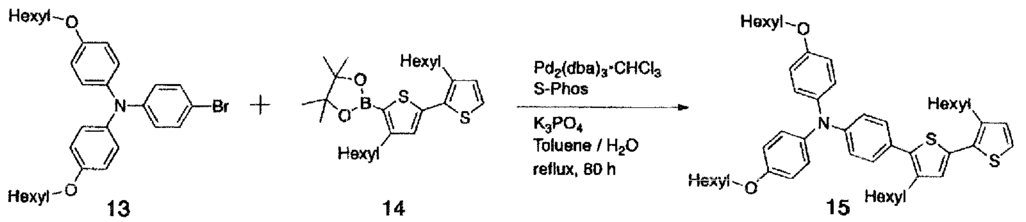


13 14 15

Compound 13 (2.68 g, 5.12 mmol) and Compound 14 (2.36 g, 5.13 mmol) shown in the reaction formula above, $Pd_2(dba)_3 \cdot CHCl_3$ (53.5 mg, 0.052 mmol), 2-dicyclohexylphosphino-2',6'-dimethoxybiphenyl (S-Phos) (42.7 mg, 0.104 mmol) and $K_3PO_4$ (3.19 g, 15.0 mmol) were dissolved in degassed toluene (50 mL) and water (5 mL) in an argon gas atmosphere followed by refluxing while heating for 80 hours. After allowing to cool on standing to room temperature, the reaction mixture was extracted with toluene. The organic layer was dried over anhydrous $Na_2SO_4$ and filtered followed by distilling off the solvent under reduced pressure. The mixture was purified by silica gel column chromatography (developing solvent: hexane:toluene = 3:1) to obtain Compound 15 (3.15 g, 4.03 mmol) in a yield of 79% as a viscous yellow liquid.

$^1$H-NMR (300 MHz , $CDCl_3$) $\delta$7.23 (d, $J_{HH}$=8.7 Hz, 2H), 7.13 (d, $J_{HH}$=5.4 Hz), 7.08 (d, $J_{HH}$=9.0 Hz, 4H), 6.95 (s, 1H), 6.93 (d, $J_{HH}$=8.7 Hz, 2H), 6.92 (d, $J_{HH}$=5.4 Hz, 1H), 6.83 (d, $J_{HH}$=9.0 Hz, 4H), 3.93 (t, $J_{HH}$=6.6 Hz, 4H), 2.77 (t, $J_{HH}$=7.8 Hz, 2H) 2.63 (t, $J_{HH}$=7.8 Hz, 2H), 1.78 (m, 4H), 1.62 (m, 4H), 1.46 (m, 4H), 1.33 (m, 20H), 0.88 (m, 12H)

$^{13}$C-NMR (75 MHz, $CDCl_3$) $\delta$155.57, 148.02, 140.42, 139.07, 138.05, 138.01, 133.20, 131.05, 129.98, 129.58, 128.27, 126.81, 125.85, 123.10, 119.68, 115.23, 68.21, 31.66, 31.59, 30.95, 30.70, 29.30, 29.24, 29.21, 28.78, 25.74, 22.60, 14.10, 14.04 (five peaks for the carbon atoms of hexyl groups are not observed due to overlapping)

Anal. Calcd. for $C_{50}H_{67}NO_2S_2$: C: 77.17, H: 8.68, N: 1.80,
Found: C: 77.03, H: 8.73, N: 1.95

(2) Introduction of Acceptor Site T

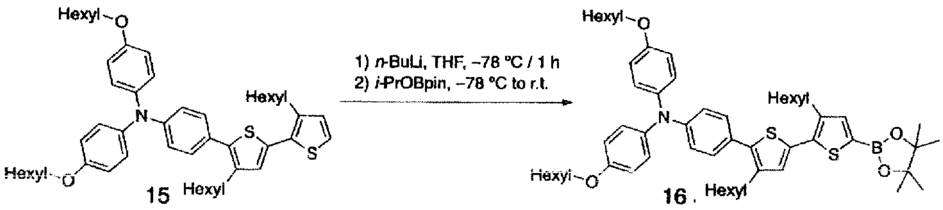


15

16

A hexane solution of n-BuLi (1.60 M, 784 μL, 1.25 mmol) was dropped into a THF (5 mL) solution of Compound 15 (976 mg, 1.25 mmol) after having cooled to -78°C. After stirring for 1 hour at -78°C, i-PrOBpin (282 μL, 1.38 mmol) was added followed by slowly raising the temperature to room temperature. After distilling off the solvent under reduced pressure, hexane was added followed by filtering by passing through Celite. The solvent was distilled off under reduced pressure, and the resulting Compound 16 was used as is in the next reaction.

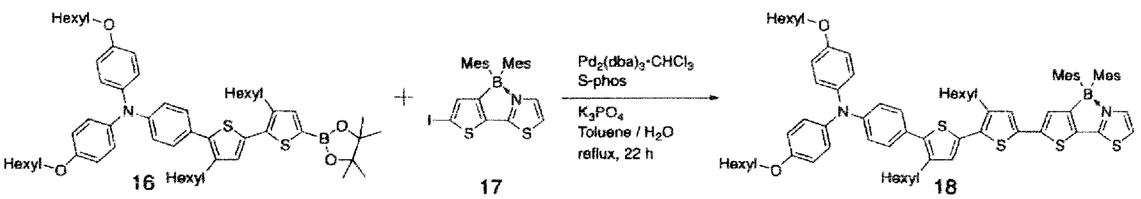


16

17

18

Compound 16 obtained in the above-mentioned reaction, Compound 17 (677 mg, 1.25 mmol) obtained according to the method described in WO 2006/070817, $Pd_2(dba)_3 \cdot CHCl_3$(13.0 mg, 12.6 μmol), S-Phos (10.4 mg, 25.3 μmol) and $K_3PO_4$ (799 mg, 3.76 mmol) were dissolved in degassed toluene (5 mL) and water (1.25 mL) in an argon gas atmosphere, and heated under reflux for 22 hours. After allowing to cool on standing to room temperature, the organic layer was separated and the aqueous layer was extracted with toluene. The organic layer was dried over anhydrous $Na_2SO_4$ and filtered followed by distilling off the solvent under reduced pressure. The mixture was purified by silica gel column chromatography (developing solvent: hexane:dichloromethane = 2:1) to obtain Compound 18 (1.15 g, 0.96 mmol) in a yield of 77% as a red solid.

$^1$H-NMR (300 MHz, $CDCl_3$) $\delta$7.66 (d, $J_{HH}$=3.9 Hz, 1H), 7.25 (s, 1H), 7.22 (d, $J_{HH}$=8.7 Hz, 2H), 7.09 (d, $J_{HH}$=8.7 Hz, 4H), 7.04 (s, 1H), 7.10 (d, $J_{HH}$=3.9 Hz, 1H), 6.98 (s, 1H), 6.93 (d, $J_{HH}$=8.7 Hz, 2H), 6.84 (d, $J_{HH}$=8.7 Hz, 4H), 6.66 (s, 4H), 3.94 (t, $J_{HH}$=6.6 Hz, 4H), 2.74 (t, $J_{HH}$=7.8 Hz, 2H), 2.63 (t, $J_{HH}$=7.8 Hz, 2H), 2.19 (s, 6H), 1.88 (s, 12H), 1.82-1.75 (m, 4H), 1.67-1.56 (m, 4H), 1.51-1.41 (m, 4H), 1.36-1.28 (m, 20H), 0.93-0.86 (m, 12H)

$^{13}$C-NMR (75 MHz, $CDCl_3$) $\delta$184.31, 166.15, 155.60, 148.12, 145.94, 142.98, 140.34,140.10, 139.74, 138.48, 138.23, 137.20, 134.09, 133.88, 132.63, 131.79, 129.54, 129.50, 128.36, 127.92, 127.49, 126.84, 126.61, 125.60, 119.59, 116.07, 115.23, 68.19, 31.63, 31.58, 30.93, 30.45, 29.42, 29.28, 29.20, 28.76, 25.73, 24.31, 22.60, 20.73, 14.10, 14.04 (five peaks for the carbon atoms of hexyl groups are not observed due to overlapping)

Anal. Calcd. for $C_{75}H_{91}BN_2S_2O_4$ : C: 75.60, H: 7.70, N: 2.35, Found: C: 75.47, H: 7.76, N: 2.42

(3) Introduction of Anchor Site A

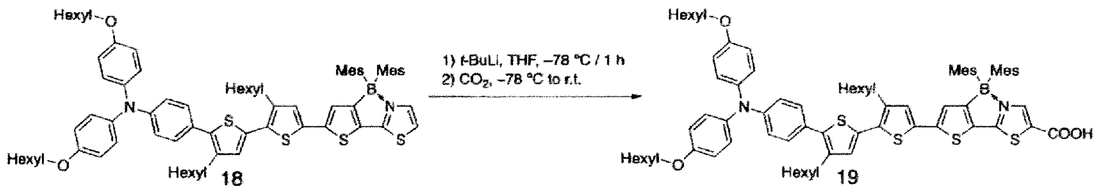


18 19

A pentane solution of t-BuLi (1.55 M, 65 μL, 0.1 mmol) was dropped into a THF (4 mL) solution of Compound 18 (119 mg, 0.10 mmol) after having cooled to -78°C. After stirring for 1 hour at -78°C, an excess of dry ice was added followed by slowly raising the temperature to room temperature. After adding saturated aqueous $NH_4Cl$ solution, the organic layer was separated and the aqueous layer was extracted three times with diethyl ether. The organic layer was dried over anhydrous $Na_2SO_4$ and filtered followed by distilling off the solvent under reduced pressure. The mixture was purified by silica gel column chromatography (developing solvent: toluene:methanol = 10:1) and PTLC (developing solvent: dichloromethane:methanol = 50:11) to obtain Compound 19 (93.0 mg, 0.075 mmol) in a yield of 75% as a dark red solid.

$^1H$-NMR (300 MHz, DMSO-$d_6$) δ7.47 (s, 1H), 7.35 (s, 1H), 7.24 (d, $J_{HH}$=8.4 Hz, 2H), 7.20 (s, 1H), 7.12 (s, 1H), 7.06 (d, $J_{HH}$=9.0 Hz, 4H), 6.92 (d, $J_{HH}$=9.0 Hz, 4H), 6.77 (d, $J_{HH}$=8.4 Hz, 2H), 6.57 (s, 4H), 3.93 (t, $J_{HH}$=6.3 Hz, 4H), 2.72 (m, 2H), 2.57 (m, 2H), 2.10 (s, 6H), 1.81 (s, 12H), 1.74-1.65 (m, 4H), 1.61-1.58 (m, 4H), 1.43-1.38 (m, 4H), 1.32-1.22 (m, 20H), 0.90-0.83 (m, 12H)

Example 2 (Synthesis of Compound)

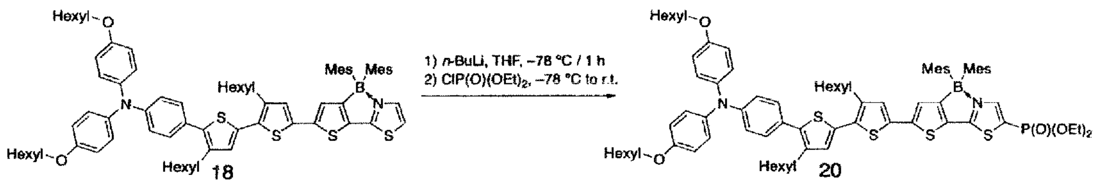


18 20

A hexane solution of *n*-BuLi (1. 54 M, 316 μL , 0.49 mmol) was dropped into a THF (5 mL) solution of Compound 18 (527 mg, 0.44 mmol) after having cooled to -78°C. After stirring for 1 hour at -78°C, diethylchlorophosphate (76 μL, 0.53 mmol) was added followed by slowly raising the temperature of the reaction mixture to room temperature. After adding water, the organic layer was separated and the aqueous layer was extracted three times with toluene. The organic layer was washed with water, dried over anhydrous $Na_2SO_4$ and filtered followed by distilling off the solvent under reduced pressure. The mixture was purified by silica gel column chromatography (developing solvent: toluene:ethyl acetate = 1:10) to obtain Compound 20 (418 mg, 0.31 mmol) in a yield of 72% as a red solid.

$^1H$-NMR (300 MHz, benzene-$d_6$) δ8.32 (d, $J_{HH}$=5.1 Hz, 1H), 7.64 (s, 1H), 7.41 (d, $J_{HH}$=9.0 Hz, 2H), 7.15-7.09 (overlapped, 7H), 6.97 (s, 1H), 6.80 (d, $J_{HH}$=9.0 Hz, 4H), 6.76 (s, 4H), 3.72 (m, 4H), 3.63 (t, $J_{HH}$=6.3 Hz, 4H), 2.70 (m, 4H), 2.19 (s, 12H), 2.15(s, 6H), 1.65-1.52 (m, 8H), 1.38-1.16 (m, overlapped, 24H), 0.90-0.82 (t, overlapped, 18H)

Example 3 (Synthesis of Compound)

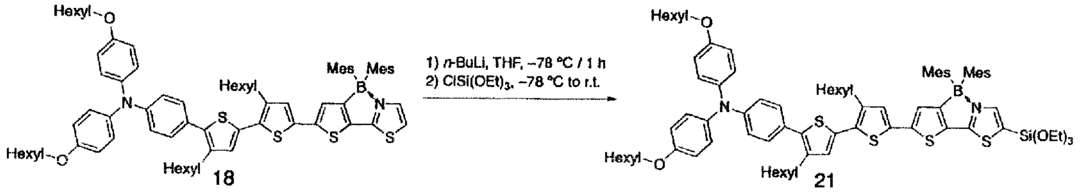


18 21

A hexane solution of n-BuLi (1.60 M, 129 μL, 0.21 mmol) was dropped into a THF (3 mL) solution of Compound 18 (204 mg, 0.17 mmol) after having cooled to -78°C. After stirring for 1 hour at -78°C, the reaction mixture was dropped into a THF (2 mL) solution of triethoxychlorosilane (134 μL, 0.68 mmol) followed by slowly raising the temperature to

room temperature. After distilling off the solvent under reduced pressure, dry hexane was added followed by filtering by passing through Celite. After distilling off the solvent, the mixture was purified by toluene GPC to obtain Compound 21 (61.2 mg, 45 μmol) in a yield of 26% as a red solid.

$^1$H-NMR (300 MHz, benzene-$d_6$) δ8.13 (s, 1H), 7.71 (s, 1H), 7.43 (d, $J_{HH}$=8.7 Hz, 2H), 7.18-7.10 (overlapped, 7H), 7.00 (s, 1H), 6.817 (d, $J_{HH}$=8.7 Hz, 4H), 6.816 (s, 4H), 3.68-3.61 (m, overlapped, 10H), 2.72 (m, 4H), 2.26 (s, 12H), 2.19 (s, 6H), 1.67-1.52 (m, 8H), 1.38-1.16 (m, overlapped, 24H), 1.03 (t, $J_{HH}$=6.9 Hz, 9H), 0.90-0.85 (t, overlapped, 12H)

Example 4 (Synthesis of Compound)

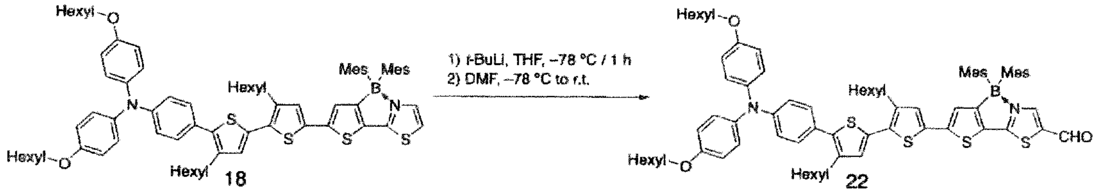


After dissolving Compound 18 obtained in (2) of Example 1 (238 mg, 0.20 mmol) in THF (4 mL) and cooling to -78°C, a pentane solution of t-BuLi (1.55 M, 129 μL, 0.2 mmol) was dropped in. After stirring for 1 hour at -78°C, DMF (15 μL, 0.20 mmol) was added followed by slowly raising the temperature to room temperature. After adding a saturated aqueous $NH_4Cl$ solution, the organic layer was separated and the aqueous layer was extracted three times with diethyl ether. The organic layer was dried over anhydrous $Na_2SO_4$ and filtered followed by distilling off the solvent under reduced pressure. The mixture was purified by silica gel column chromatography (developing solvent: hexane:toluene = 1:3) to obtain Compound 22 (158 mg, 0.13 mmol) in a yield of 65% as a dark red solid.

$^1$H-NMR (300 MHz, $CDCl_3$) δ9.81 (s, 1H), 8.15 (s, 1H), 7.29 (s, 1H), 7.22 (d, $J_{HH}$=8.7 Hz, 2H), 7.12 (s, 1H), 7.09 (d, $J_{HH}$=9.0 Hz, 4H), 7.00 (s, 1H), 6.92 (d, $J_{HH}$=8.7 Hz, 2H), 6.84 (d, $J_{HH}$=9.0 Hz, 4H), 6.69 (s, 4H), 3.93 (t, $J_{HH}$=6.6 Hz, 4H), 2.75 (t, $J_{HH}$=7.8 Hz, 2H), 2.63 (t, $J_{HH}$=7.8 Hz, 2H), 2.20 (s, 6H), 1.90 (s, 12H), 1.82-1.73 (m, 4H), 1.64-1.60 (m, 4H), 1.48-1.44 (m, 4H), 1.33-1.22 (m, 20H), 0.93-0.86 (m, 12H)

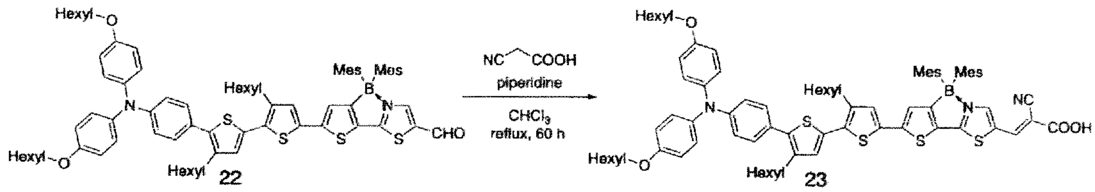


Compound 22 (58.4 mg, 0.048 mmol) was dissolved in chloroform (2 mL) followed by dropping in cyanoacetic acid (8.1 mg, 0.096 mmol) and piperidine (9.5 μL, 0.096 mmol) and refluxing while heating for 60 hours. After adding saturated aqueous $NH_4Cl$ solution, the organic layer was separated and the aqueous layer was extracted three times with diethyl ether. The organic layer was dried over anhydrous $Na_2SO_4$ and filtered followed by distilling off the solvent under reduced pressure. The mixture was purified by PTLC (developing solvent: dichloromethane: methanol = 6:1) to obtain Compound 23 (42.5 mg, 0.033 mmol) in a yield of 69% as a black solid.

$^1$H-NMR (300 MHz, DMSO-$d_6$) δ8.48 (s, 1H), 8.30 (s, 1H), 7.43 (s, 1H), 7.26 (s, 1H), 7.23 (d, $J_{HH}$=9.0 Hz, 2H), 7.14 (s, 1H), 7.06 (d, $J_{HH}$=9.0 Hz, 4H), 6.91 (d, $J_{HH}$=9.0 Hz, 4H), 6.76 (d, $J_{HH}$=9.0 Hz, 2H), 6.57 (s, 4H), 3.93 (t, $J_{HH}$=6.3 Hz, 4H), 2.73 (m, 2H), 2.59 (m, 2H), 2.10 (s, 6H), 1.81 (s, 12H), 1.74-1.67 (m, 4H), 1.62-1.53 (m, 4H), 1.43-1.35 (m, 4H), 1.33-1.22 (m, 20H), 0.90-0.82 (m, 12H)

Example 5 (Synthesis of Compound)

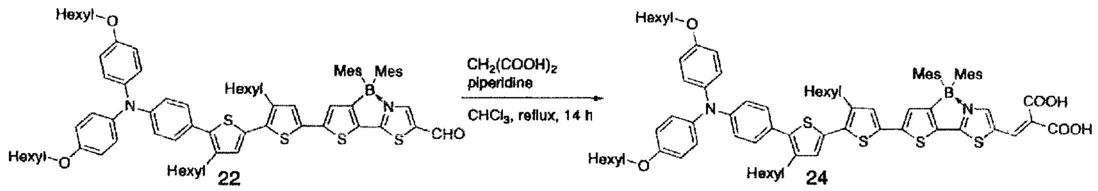


Malonic acid (31.0 mg, 0.30 mmol) and piperidine (48 µL, 0.49 mmol) were added to a chloroform (1 mL) solution of Compound 22 (120 mg, 0.098 mmol) at room temperature followed by refluxing the mixture for 14 hours. After lowering the temperature to room temperature, 2 M aqueous hydrochloric acid solution (3 mL) was added. The organic layer was separated and the aqueous layer was extracted three times with diethyl ether. The organic layer was washed with water, dried over anhydrous $Na_2SO_4$ and filtered followed by distilling off the solvent under reduced pressure. The mixture was purified by PTLC (developing solvent: dichloromethane :methanol = 8:1) to obtain Compound 24 (102 mg, 0.078 mmol) in a yield of 80% as a deep red solid.

$^1$H-NMR (300 MHz, DMSO-$d_6$) δ8.42 (s, 1H), 8.30 (s, 1H),7.40 (s, 1H), 7.24 (d, $J_{HH}$=9.0 Hz, 2H), 7.22 (s, 1H), 7.13 (s, 1H), 7.06 (d, $J_{HH}$=9.0 Hz, 4H), 6.92 (d, $J_{HH}$=9.0 Hz, 4H), 6.76 (d, $J_{HH}$=9.0 Hz, 2H), 6. 55 (s, 4H), 3.93 (t, $J_{HH}$=6.3 Hz, 4H), 2. 73 (m, 2H), 2.59 (m, 2H), 2.10 (s, 6H), 1.81 (s, 12H), 1.74-1.65 (m, 4H), 1.62-1.52 (m, 4H), 1.45-1.35 (m, 4H), 1.33-1.18 (m, overlapped, 20H), 0.90-0.82 (t, overlapped, 12H)

Example 6 (Synthesis of Compound)

<u>(1) Reparation of Donor Site D</u>

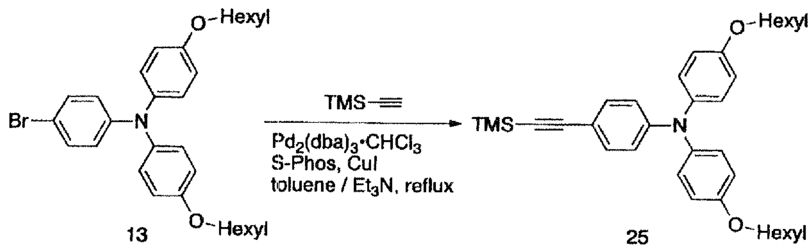


13 25

Compound 13 (2.89 g, 5.5 mol), trimethylsilylacetylene (3.8 mL, 27 mmol), $Pd_2(dba)_3$·$CHCl_3$ (93 mg, 0.09 mmol), S-Phos (148 mg, 0.36 mmol) and CuI (68.6 mg, 0.36 mmol) were dissolved in degassed toluene (36 mL) and triethylamine (4 mL) in an argon gas atmosphere followed by refluxing while heating for 20 hours. After allowing to cool on standing to room temperature, saturated aqueous $NH_4Cl$ solution was added. The organic layer was separated and the aqueous layer was extracted three times with diethyl ether. The organic layer was dried over anhydrous $Na_2SO_4$ and filtered followed by distilling off the solvent under reduced pressure. After dispersing in a solvent (hexane: toluene = 5:1) and passing through a silica gel pad, the solvent was distilled off and the resulting viscous yellow liquid containing Compound 25 was used as is in the next reaction.

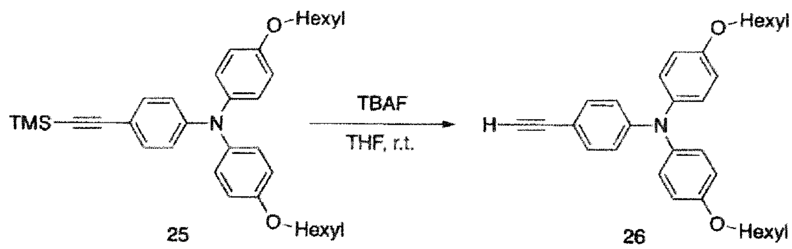


25 26

A THF solution (1.0 M, 10 mL, 10 mmol) of tetrabutylammonium fluoride was added to Compound 25 (2.78 g, 5.1 mmol) followed by stirring for 4 hours at room temperature. The solvent was distilled off under reduced pressure and the mixture was purified by silica gel column chromatography (developing solvent: hexane:dichloromethane = 3:1) to obtain Compound 26 (1.21 g, 2.6 mmol) in a yield of 50% as a viscous yellow liquid.

$^1$H-NMR (300 MHz, $C_6D_6$) δ7.38 (d, $J_{HH}$=7.2 Hz, 2H), 7.01 (d, $J_{HH}$=7.2 Hz, 4H), 6.89 (d, $J_{HH}$=7.2 Hz, 2H), 6.75

(d, $J_{HH}$=7.2 Hz, 4H), 3.61 (t, $J_{HH}$=6.3 Hz, 4H), 2.77 (s, 1H), 1.62-1.57 (m, 4H), 1.35-1.30 (m, 4H), 1.24-1.17 (m, 8H), 0.86 (t, $J_{HH}$=6.6 Hz, 6H)

(2) Preparation of Spacer Site Q and Donor Site D

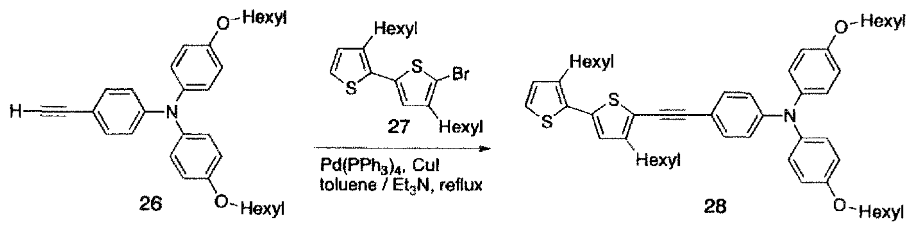


26 28

Compound 26 (649 mg, 1.38 mmol), Compound 27 (591 mg, 1.42 mmol), $Pd(PPh)_4$ (62 mg, 0.054 mmol) and CuI (68.6 mg, 0.36 mmol) were dissolved under argon atmosphere in degassed toluene (9 mL) and triethylamine (3 mL) followed by refluxing while heating for 26 hours. After allowing to cool on standing to room temperature, saturated aqueous $NH_4Cl$ solution was added. The organic layer was separated and the aqueous layer was extracted three times with toluene. The organic layer was dried over anhydrous $Na_2SO_4$ and filtered followed by distilling off the solvent under reduced pressure. The mixture was purified by silica gel column chromatography (developing solvent: hexane:dichloromethane = 3:1) and toluene GPC to obtain Compound 28 (272 mg, 0.34 mmol) in a yield of 25% as a viscous yellow liquid.

$^1$H-NMR (300 MHz, $C_6D_6$) δ7.41 (d, $J_{HH}$=8.7 Hz, 2H), 7.11 (d, $J_{HH}$=5.1 Hz, 1H), 7.04 (d, $J_{HH}$=9.0 Hz, 4H) 7.01 (s, 1H), 6.96 (d, $J_{HH}$=8.7 Hz, 2H), 6.77 (d, $J_{HH}$=9.0 Hz, 4H), 6.68 (d, $J_{HH}$=5.1 Hz, 1H), 3.62 (t, $J_{HH}$=6.3 Hz, 4H), 2.81-2.71 (m, 4H), 1.64-1.55 (m, 8H), 1.38-1.13 (m, 24H), 0.89-0.82 (m, 12H)

(3) Introduction of Acceptor Site T

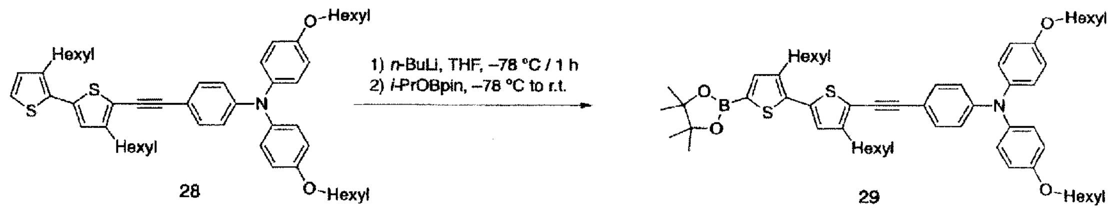


28 29

A THF (3 mL) solution of Compound 28 (243 mg, 0.30 mmol) was cooled to -78°C followed by dropping in a hexane solution of *n*-BuLi (1.60 M, 199 μl, 0.32 mmol). After stirring for 1 hour at -78°C, i-PrOBpin (68 μL, 0.33 mmol) was added following slowly raising the temperature to room temperature. The resulting Compound 29 was used as is in the next reaction.

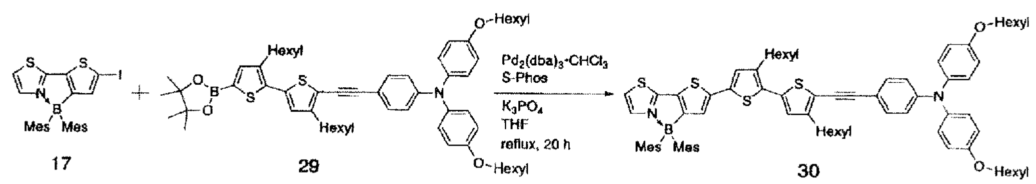


17 29 30

Compound 17 (163 mg, 0.30 mmol), $Pd_2(dba)_3 \cdot CHCl_3$ (3.2 mg, 3.1 μmol), S-Phos (5.3 mg, 12.9 μmol) and $K_3PO_4$ (205 mg, 0.97 mmol) were dissolved in a THF (3 mL) solution of Compound 29 followed by refluxing while heating for 20 hours. After allowing to cool on standing to room temperature, saturated aqueous $NH_4Cl$ solution (3 mL) was added. The organic layer was separated and the aqueous layer was extracted three times with toluene. The organic layer was dried over anhydrous $Na_2SO_4$ and filtered followed by distilling off the solvent under reduced pressure. The mixture was purified by silica gel column chromatography (developing solvent: hexane:toluene = 1:1) to obtain Compound 30 (286 mg, 0.24 mmol) in a yield of 78% as a red solid.

$^1$H-NMR (300 MHz, $C_6D_6$ δ7.64 (s, 1H). 7.42 (d, $J_{HH}$=8.7 Hz, 2H), 7.22 (d, $J_{HH}$=3.6 Hz, 1H), 7.04 (d, $J_{HH}$=8.17 Hz, 4H), 6.97 (d, $J_{HH}$=8.7 Hz, 2H). 6.94 (s, 1H), 6.90 (s, 1H), 6.82 (s, 4H), 6.77 (d, $J_{HH}$=8.7 Hz, 4H), 5.64 (d, $J_{HH}$=3.6 Hz, 1H), 3.61 (t, $J_{HH}$=6.3 Hz, 4H), 2.76 (m, 2H), 2.62 (m, 2H), 2.20 (s, 6H), 2.17 (s, 12H), 1.65-1.42 (m, 8H), 1.35-1.17 (m, 24H), 0.89-0.84 (m, 12H)

Introduction of Anchor Site A

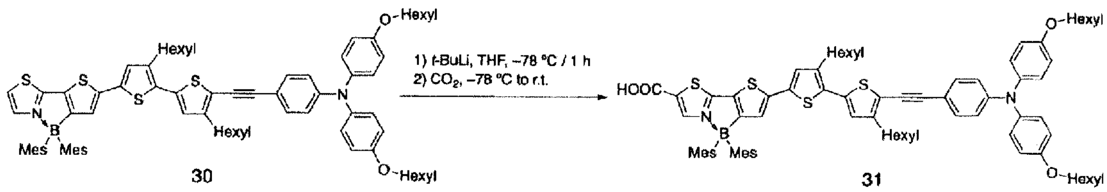


30

31

A THF (2.4 mL) solution of Compound 30 (71.2 mg, 58.6 μmol) was cooled to -78°C followed by dropping in a pentane solution of *t*-BuLi (1.55 M, 38 μl, 59 μmol). After stirring for 1 hour at -78°C, an excess amount of dry ice was added followed by slowly raising the temperature to room temperature. After adding a saturated aqueous $NH_4Cl$ solution, the organic layer was separated and the aqueous layer was extracted three times with diethyl ether. The organic layer was dried over anhydrous $Na_2SO_4$ and filtered followed by distilling off the solvent under reduced pressure. The mixture was purified by silica gel column chromatography (developing solvent: dichloromethane:methanol = 10:1) and PTLC (developing solvent: dichloromethane:methanol = 20:3) to obtain Compound 31 (46.6 mg, 37 μmol) in a yield of 63% as a dark red solid.

$^1$H-NMR (300 MHz, DMSO-$d_6$) δ7.51 (s, 1H), 7.31 (s, 1H), 7.25 (d, $J_{HH}$=8.1 Hz, 2H), 7.21 (s, 1H), 7.09 (s, 1H), 7.04 (d, $J_{HH}$=8.4 Hz, 4H), 6.90 (d, $J_{HH}$=8.4 Hz, 4H), 6.65 (d, $J_{HH}$=8.1 Hz, 2H), 6.56 (s, 4H), 3.91 (t, $J_{HH}$=6.3 Hz, 4H), 2.75-2.61 (m, 4H), 2.09 (s, 6H), 1.80 (s, 12H), 1.70-1.63 (m, 4H), 1.62-1.55 (m, 4H), 1.43-1.20 (m, 24H), 0.90-0.80 (m, 12H)

Example 7 (Synthesis of Compound)

(1) Introduction of Anchor Site A into Acceptor Site T

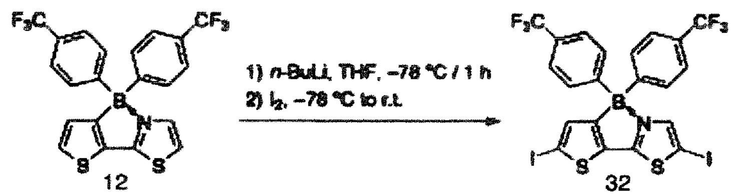


12

32

A THF (1 mL) solution of Compound 12 (91.0 mg, 0.195 mmol) was cooled to -78°C followed by dropping in a hexane solution of n-BuLi (1.60 M, 268 μl, 0.428 mmol). After stirring for 1 hour at -78°C, iodine (514 mg, 0.473 mmol) was added followed by slowly raising the temperature of the reaction mixture to room temperature. After adding aqueous $Na_2SO_3$ solution, the organic layer was separated and the aqueous layer was extracted three times with dichloromethane. The organic layer was dried over anhydrous $Na_2SO_4$ and filtered followed by distilling off the solvent under reduced pressure. The mixture was purified by silica gel column chromatography (developing solvent: hexane:dichloromethane = 2:1) to obtain Compound 32 (138 mg, 0.192 mmol) in a yield of 98% as a pale yellow solid (melting point: 210-212°C).

$^1$H-NMR (600 MHz, $CDCl_3$) δ7.74 (s, 1H), 7.49 (s, 1H), 7.48 (d, $J_{HH}$=7.7 Hz, 4H), 7.27 (s, $J_{HH}$=7.7 Hz, 4H)

$^{13}$C-NMR (150 MHz, $CDCl_3$) δ179.68, 169.71, 151.04, 140.67, 138.91, 136.62, 132.78, 128.58 (q, $J_{CF}$=31.8 Hz), 124.52 (q, $J_{CF}$=271.6 Hz), 124.37 (q, $J_{CF}$=3.8 Hz), 87.28, 66.22

$^{11}$B-NMR (192 MHz, $CDCl_3$) δ1.28

$^{19}$F-NMR (565 MHz, $CDCl_3$) δ-62.88

Anal. Calcd. for $C_{21}H_{10}BF_6NS_2$: C: 35.08, H: 1.40, N: 1.95, Found: C: 35.24, H: 1.36, N: 2.21

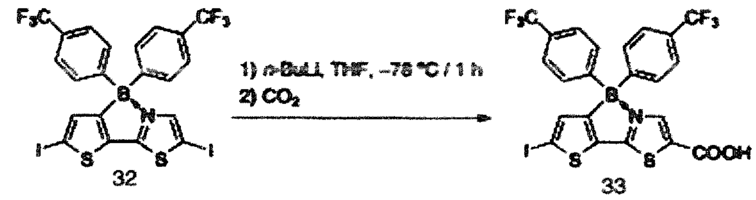


32 33

A THF (13.5 mL) solution of Compound 32 (1.00 g, 1.39 mmol) was cooled to -78°C followed by dropping in a hexane solution of *n*-BuLi (1.59 M, 875 μl, 1.39 mmol). After stirring for 1 hour at -78°C, an excess amount of dry ice was added followed by slowly raising the temperature to room temperature. After adding 2 M aqueous hydrochloric acid solution (10 mL), the organic layer was separated and the aqueous layer was extracted three times with dichloromethane. The organic layer was washed with water, dried over anhydrous $Na_2SO_4$ and filtered followed by distilling off the solvent under reduced pressure. The mixture was purified by silica gel column chromatography (developing solvent:

dichloromethane→dichloromethane: methanol = 10:1) to obtain Compound 33 (733 mg, 0.081 mmol) in a yield of 83% as a yellow solid (melting point: 235-237°C (decomposed)).

$^1$H-NMR (600 MHz, DMSO-$d_6$) δ14.17 (br s, 1H), 8.87 (s, 1H), 7.70 (s, 1H), 7.49 (d, $J_{HH}$=7.7 Hz, 4H), 7.38 (d, $J_{HH}$=7.7 Hz, 4H)

$^{13}$C-NMR (150 MHz, DMSO-$d_6$) δ180.37, 168.43, 161.22, 152.50, 139.47, 138.12, 137.10, 132.96, 130.55, 126.59 (q, $J_{CF}$=31.4Hz), 124.70 (q, $J_{CF}$=271.5 Hz), 123.88 (q, $J_{CF}$=3.9 Hz), 93.67

$^{11}$B-NMR (192 MHz, DMSO-$d_6$) δ0.13

$^{19}$F-NMR (565 MHz, DMSO-$d_6$) δ-61.30

Anal. Calcd. for $C_{22}H_{11}BF_6INO_2S_2$: C: 41.47, H: 1.74, N: 2.20, Found: C: 41.67, H: 1.73, N: 2.34

<u>(2) Introduction of Spacer Unit Q and Donor Unit D</u>

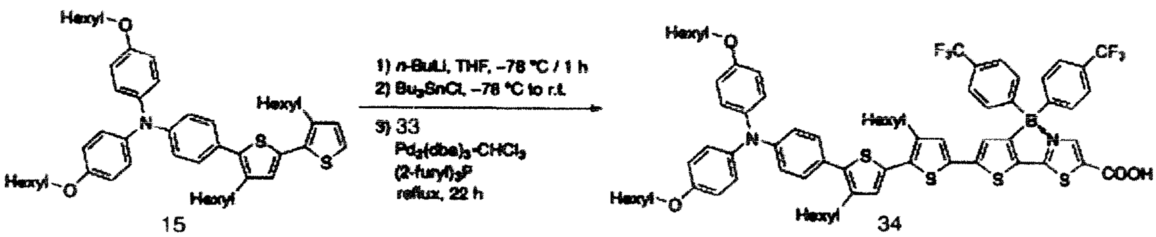


15 34

A THF (4 mL) solution of Compound 15 (321 mg, 0.412 mmol) was cooled to -78°C followed by dropping in a hexane solution of *n*-BuLi (1. 60 M, 258 μl, 0.412 mmol). After stirring for 1 hour at -78°C, tributyltin chloride (112 μL, 0.412 mmol) was added followed by slowly raising the temperature of the reaction mixture to room temperature. Compound 33 (265 mg, 0.416 mmol), $Pd_2(dba)_3 \cdot CHCl_3$ (8.42 mg, 8.13 μmol) and trifurylphosphine (7.71 mg, 33.2 μmol) were added to this mixture followed by refluxing while heating for 22 hours. After adding 1 M aqueous hydrochloric acid solution (5 mL), the organic layer was separated and the aqueous layer was extracted three times with diethyl ether. The organic layer was washed with water, dried over anhydrous $Na_2SO_4$ and filtered followed by distilling off the solvent under reduced pressure. The mixture was purified by silica gel column chromatography (developing solvent: dichloromethane) and PTLC (developing solvent: dichloromethane:methanol = 10:1) to obtain Compound 34 (114 mg, 0.088 mmol) in a yield of 21% as a deep red solid.

$^1$H-NMR (600 MHz , DMSO-$d_6$) δ8.42 (s, 1H), 7.60 (s, 1H), 7.49 (d, $J_{HH}$=8.0 Hz, 4H), 7.43 (d, $J_{HH}$=8.0 Hz, 4H), 7.42 (s, 1H), 7.22 (d, $J_{HH}$=8.7 Hz, 2H), 7.09 (s, 1H), 7.04 (d, $J_{HH}$=8.9 Hz, 4H), 6.89 (d, $J_{HH}$=8.9 Hz, 4H), 6.78 (d, $J_{HH}$=8.7 Hz, 2H), 3.94 (t, $J_{HH}$=6.5 Hz, 4H), 2.74 (m, 2H), 2.60 (m, 2H), 1.72-1.67 (m, 4H), 1.65-1.60 (m, 2H), 1.59-1.54 (m, 2H), 1.43-1.38 (m, 4H), 1.37-1.20 (m, overlapped, 20H), 0.87 (t, $J_{HH}$=7.1 Hz, 6H), 0.83 (t, $J_{HH}$=7.1 Hz, 3H), 0.82 (t, $J_{HH}$=7.1 Hz, 3H)

$^{13}$C-NMR (150 MHz, DMSO-$d_6$) δ179.09, 167.31, 160.33, 155.38, 152.83, 147.93, 146.72, 139.99, 139.36, 137.99, 137.88, 135.94, 132.74, 132.58, 132.53, 131.32, 131.03, 130.27, 129.08, 128.83, 128.54, 126.78, 126.34 (q, $J_{CF}$=31.3 Hz), 124.85, 124.45 (q, $J_{CF}$=271.5 Hz), 124.18, 123.55 (q, $J_{CF}$=3.8 Hz), 118.34, 115.42, 67.58, 30.65, 30.64, 30.63, 29.70, 29.38, 28.51, 28.43, 28.18, 28.05, 27.81, 24.86, 21.68, 21.64, 21.61, 13.48, 13.47 (one aliphatic signal is

not observed due to overlapping)

$^{11}B$-NMR (192 MHz, DMSO-$d_6$) δ-0.18

$^{19}F$-NMR (565 MHz, DMSO-$d_6$) δ-61.37

HRMS(FAB) : 1286.4758 ($M^+$)

Calcd. for $C_{72}H_{77}BF_6N_2O_4S_4$: 1286.4763

Example 8 (Synthesis of Compound)

(1) Preparation of Spacer Site Q and Donor Site D

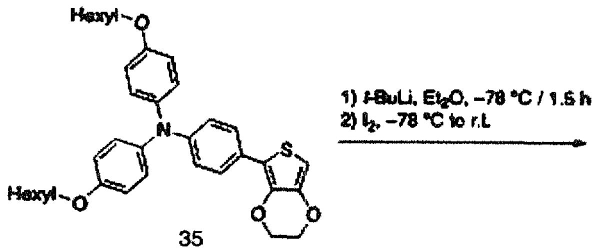


35 36

An $Et_2O$ (25 mL) solution of Compound 35 (1.45 g, 2.47 mmol) was cooled to -78°C followed by dropping in a pentane solution of t-BuLi (1.55 M, 1.75 mL, 2.71 mmol). After stirring for 1.5 hours at -78°C, iodine (759 mg, 2.99 mmol) was added followed by slowly raising the temperature of the reaction mixture to room temperature. After adding aqueous $Na_2SO_3$ solution, the organic layer was separated and the aqueous layer was extracted three times with diethyl ether. The organic layer was dried over anhydrous $Na_2SO_4$ and filtered followed by distilling off the solvent under reduced pressure. The mixture was purified by silica gel column chromatography (developing solvent: hexane:dichloromethane = 1:1) to obtain Compound 36 (1.46 g, 2.052 mmol) in a yield of 83% as a viscous yellow liquid.

$^1H$-NMR (300 MHz, benzene-$d_6$) δ7.67 (d, $J_{HH}$=8.4 Hz, 2H), 7.11 (d, $J_{HH}$=8.4 Hz, 2H), 7.10 (d, $J_{HH}$=8.7 Hz, 4H), 6.79 (d, $J_{HH}$=8.7 Hz, 4H), 3.63 (t, $J_{HH}$=6.3 Hz, 4H), 3.30-3.21 (m, 4H), 1.63-1.56 (m, 4H), 1.38-1.27 (m, 4H), 1.25-1.16 (m, 8H), 0.87 (t, $J_{HH}$=6.3 Hz, 6H)

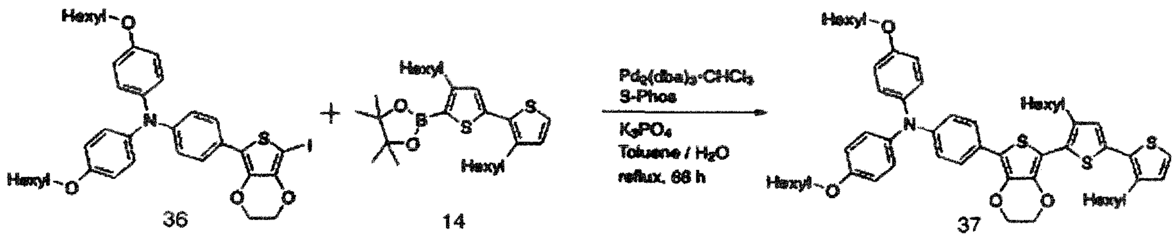


36 14 37

Compound 36 (533 mg, 0.75 mmol), Compound 14 (417 mg, 0.91 mmol), $Pd_2(dba)_3 \cdot CHCl_3$ (7.8 mg, 7.5 μmol), S-Phos (12.3 mg, 30 μmol) and potassium phosphate (481 mg, 2.27 mmol) were dissolved in degassed toluene (10 mL) and water (2.5 mL) in an argon gas atmosphere followed by refluxing while heating for 66 hours. After cooling to room temperature, water was added to the mixture followed by extracting three times with toluene. The organic layer was dried over anhydrous $Na_2SO_4$ and filtered followed by distilling off the solvent under reduced pressure. The mixture was purified by silica gel column chromatography (developing solution: toluene) and toluene GPC to obtain Compound 37 (461 mg, 0.50 mmol) in a yield of 67% as a viscous red liquid.

$^1H$-NMR (300 MHz, benzene-$d_6$) δ7.84 (d, $J_{HH}$=9.0 Hz, 2H), 7.19-7.09 (overlapped, 8H), 6.80 (d, $J_{HH}$=8.7 Hz, 4H), 6.79 (s, 1H), 6.74 (d, $J_{HH}$=5.1 Hz, 1H), 3.64 (t, $J_{HH}$=6.3 Hz, 4H), 3.44-3.37 (m, 4H), 2.90 (t, $J_{HH}$=7.8 Hz, 2H), 2.83 (t, $J_{HH}$=7.8 Hz, 2H), 1.70-1.56 (m, 8H), 1.389-1.27 (m, 8H), 1.25-1.16 (m, 16H), 0.89-0.83 (t, overlapped, 12H)

(2) Introduction of Acceptor Site T and Anchor Site A

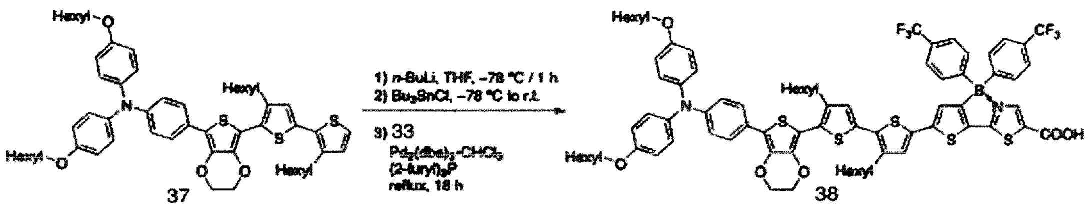


37 38

A THF (3 mL) solution of Compound 37 (81.4 mg, 88.6 μmol) was cooled to -78°C followed by dropping in a hexane solution of n-BuLi (1.60 M, 55 μl, 88 μmol). After stirring for 1 hour at -78°C, tributyltin chloride (24 μL, 89 μmol) was added followed by slowly raising the temperature of the reaction mixture to room temperature. Compound 33 (57.4 mg, 90.1 μmol), $Pd_2(dba)_3{\cdot}CHCl_3$ (0.95 mg, 0.92 μmol) and trifurylphosphine (0.91 mg, 3.9 μmol) were added followed by refluxing while heating for 18 hours. After adding saturated aqueous ammonium chloride solution (5 mL), the organic layer was separated and the aqueous layer was extracted three times with diethyl ether. The organic layer was washed with water, dried over anhydrous $Na_2SO_4$ and filtered followed by distilling off the solvent under reduced pressure. The mixture was purified by silica gel column chromatography (developing solvent: toluene:methanol = 10:1) and PTLC (developing solvent: toluene:methanol = 10:1) to obtain Compound 38 (36.0 mg, 25.2 μmol) in a yield of 28% as a deep red solid.

$^1$H-NMR (300 MHz, DMSO-$d_6$) δ8.74 (s, 1H), 7.68 (s, 1H), 7.53-7.43 (overlapped, 11H), 7.11 (s, 1H), 6.99 (d, $J_{HH}$=8.7 Hz, 4H), 6.89 (d, $J_{HH}$=8.7 Hz, 4H), 6.78 (d, $J_{HH}$=8.7 Hz, 2H), 4.34 (br s, 4H), 3.92 (t, $J_{HH}$=6.3 Hz, 4H), 2.73 (m, 2H), 2.60 (m, 2H), 1.71-1.52 (m, 8H), 1.43-1.10 (m, 24H), 0.95-0.85 (t, overlapped, 12H)

Example 9 (Synthesis of Compound)

<u>(1) Preparation of Acceptor Site T</u>

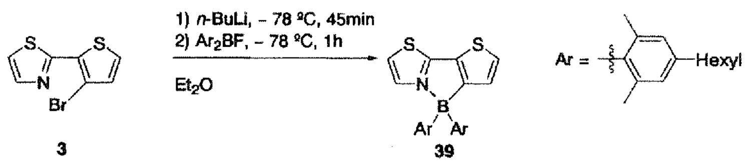


3 39

An $Et_2O$ (80 mL) solution of Compound 3 (3.98 g, 16.2 mmol) was cooled to -78°C followed by dropping in a hexane solution of n-BuLi (1.54 M, 10.4 mL, 16.0 mmol). After stirring for 45 minutes at -78°C, an $Et_2O$ (20 mL) solution of $Ar_2BF$ (6.54 g, 16.0 mmol) (Ar = 2,4-dimethyl-4-hexylfluorenyl synthesized in accordance with a known method (Non-Patent Document: Macromolecules, 2007, 40, 3898)) was dropped in followed by stirring for 1 hour. After adding water, the temperature was slowly raised to room temperature. The organic layer was separated and the aqueous layer was extracted three times with dichloromethane. The organic phase was sequentially washed with water and saturated aqueous sodium chloride solution in that order followed by drying with anhydrous $Na_2SO_4$, filtering and distilling off the solvent under reduced pressure. The mixture was purified by silica gel column chromatography (developing solvent: hexane:dichloromethane = 2:1, $R_f$ = 0.48) to obtain Compound 39 (4.37 g. 7.87 mmol) in a yield of 49% as a pale yellow solid.

$^1$H-NMR (300 MHz, $CDCl_3$) δ7.78 (d, $J_{HH}$=3.6 Hz, 1H), 7.70 (d, $J_{HH}$=3.6 Hz, 1H), 7.46 (d, $J_{HH}$=4.8 Hz, 1H), 7.24 (d, $J_{HH}$=4.8 Hz, 1H), 7.04 (d, $J_{HH}$=3.6 Hz, 1H), 6.62 (s, 4H), 2.42 (t, $J_{HH}$=8.1 Hz, 4H), 1.84 (s, 12H), 1.47-1.60 (m, 4H), 1.23-1.36 (m, 12H), 0.87 (t, $J_{HH}$=6.6 Hz, 6H)

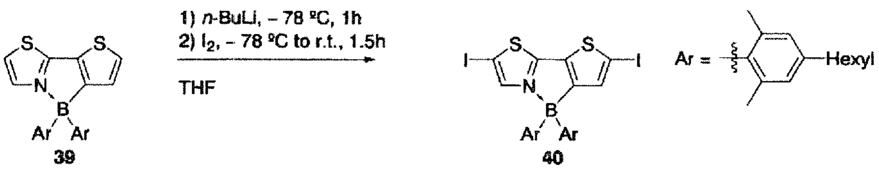


39 40

A THF (40 mL) solution of Compound 39 (4.40 g, 7.92 mmol) was cooled to -78°C followed by dropping in a hexane solution of n-BuLi (1.58 M, 10.5 mL, 16.6 mmol). After stirring for 1 hour at -78°C, iodine (5.06 g, 19.9 mmol)

was added followed by stirring for 1.5 hours while slowly raising the temperature to room temperature. After adding water and aqueous $Na_2S_2O_3$ solution, the organic layer was removed and the aqueous layer was extracted with dichloromethane. The organic layer was sequentially washed with water and saturated aqueous sodium chloride solution in that order, dried over anhydrous $Na_2SO_4$ and filtered followed by distilling off the solvent under reduced pressure. The mixture was purified by silica gel column chromatography (developing solvent: hexane:dichloromethane = 3:1, $R_f$ = 0.33) to obtain Compound 40 (5.97 g, 7.39 mmol) in a yield of 93% as a pale yellow solid.

$^1$H-NMR (300 MHz, $CDCl_3$) δ7.65 (s, 1H), 7.36 (s, 1H), 6.64 (s, 4H), 2.44 (t, $J_{HH}$=8.0 Hz, 4H), 1.83 (s, 12H), 1.49-1.61 (m, 4H), 1.23-1.35 (m, 12H), 0.88 (t, $J_{HH}$=6.9 Hz, 6H)

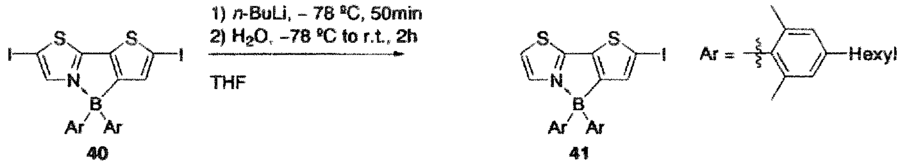


A THF (90 mL) solution of Compound 40 (5.97 g, 7.39 mmol) was cooled to -78°C followed by dropping in a hexane solution of n-BuLi (1.58 M, 4.70 mL, 7.43 mmol). After stirring for 50 minutes at -78°C, excess water was added followed by stirring for 2 hours while slowly raising the temperature to room temperature. The organic layer was removed and the aqueous layer was extracted with hexane. The organic layer was sequentially washed with water and saturated aqueous sodium chloride solution in that order, dried over anhydrous $Na_2SO_4$ and filtered followed by distilling off the solvent under reduced pressure. The mixture was purified by silica gel column chromatography (developing solvent: hexane:dichloromethane = 1:1, $R_f$ = 0.51) to obtain Compound 41 (3.41 g, 7.39 mmol) in a yield of 68% as a pale yellow solid.

$^1$H-NMR (300 MHz, $CDCl_3$) δ7.70 (d, $J_{HH}$=3.6 Hz, 1H), 7.40 (s, 1H), 7.05 (d, $J_{HH}$=3.6 Hz, 1H), 6.62 (s, 4H), 2.43 (t, $J_{HH}$=8.1 Hz, 4H), 1.82 (s, 12H), 1.48-1.61 (m, 4H), 1.23-1.37 (m, 12H), 0.87 (t, $J_{HH}$=6.8 Hz, 6H)

(2) Introduction of Acceptor Site T into Donor Site D and Spacer Site Q

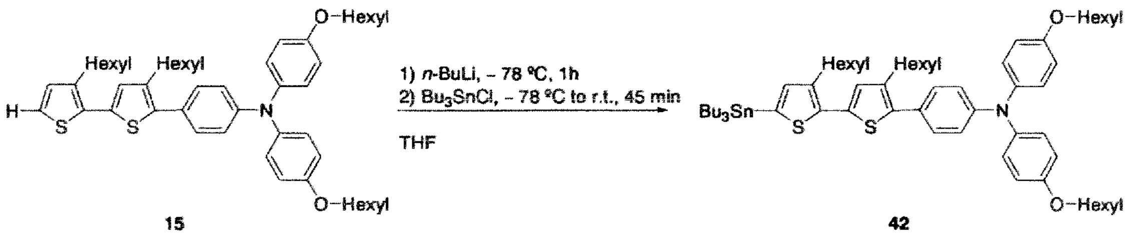


A THF (15 mL) solution of Compound 15 (1.13 g, 1.45 mmol) was cooled to -78°C followed by dropping in a hexane solution of n-BuLi (1.58M, 1.0 mL, 1.58 mmol). After stirring for 1 hour at -78°C, tributyltin chloride (0.45 mL, 1.65 mmol) was added followed by stirring for 45 minutes while slowly raising the temperature to room temperature. After adding water, the organic layer was removed and the aqueous layer was extracted with hexane. The organic layer was sequentially washed with water and saturated aqueous sodium chloride solution in that order, dried over anhydrous $Na_2SO_4$ and filtered followed by distilling off the solvent under reduced pressure. The mixture was purified by alumina column chromatography (developing solvent: hexane:ethyl acetate = 40:1, $R_f$ = 0.56) to obtain Compound 42 (1.41 g, 1.32 mmol) in a yield of 91% as a viscous yellow liquid.

$^1$H-NMR (300 MHz, $CDCl_3$) δ7.23 (d, $J_{HH}$=8.4 Hz, 2H), 7.08 (d, $J_{HH}$=8.9 Hz, 4H), 6.95 (s, 1H), 6.94 (s, 1H), 6.92 (d, $J_{HH}$=8.4 Hz, 2H), 3.93 (t, $J_{HH}$=6.6 Hz, 4H), 2.79 (t, $J_{HH}$=8.1Hz, 2H), 2.63 (t, $J_{HH}$=8.1 Hz, 2H), 1.78 (quint, $J_{HH}$=6.6 Hz, 4H), 1.51-1.70 (m, 10H), 1.21-1.50 (m, 30H), 1.10 (t, $J_{HH}$=7.8 Hz, 6H), 0.82-0.93 (m, 21H)

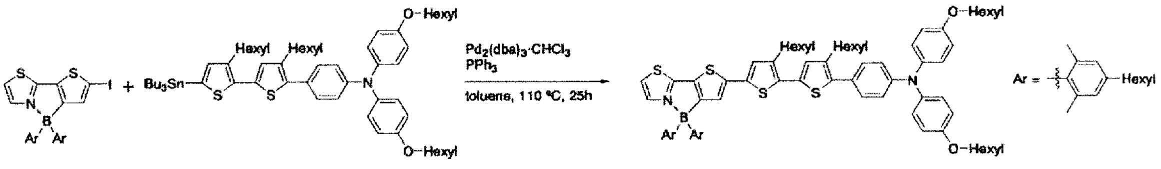


41 42 43

Compound 41 (900 mg, 1.32 mmol), Compound 42 (1.41 g, 1.32 mmol), $Pd_2(dba)_3 \cdot CHCl_3$ (34.6 mg, 0.334 mmol) and $PPh_3$ (68.9 mg, 0.262 mmol) were dissolved in degassed anhydrous toluene (8 mL) in an argon atmosphere followed by stirring for 25 hours at 110°C. After cooling to room temperature and distilling off the solvent under reduced pressure, the mixture was purified by silica gel column chromatography (developing solvent: hexane:ethyl acetate = 20: 1, $R_f$ = 0.36) to obtain Compound 43 (1.46 g, 1.10 mmol) in a yield of 83% as a viscous red liquid.

$^1$H-NMR (300 MHz, $CDCl_3$) δ7.67 (d, $J_{HH}$=3.7 Hz, 1H), 7.23 (d, $J_{HH}$=8.6 Hz, 2H), 7.08 (d, $J_{HH}$=8.9 Hz, 4H), 7.04 (s, 1H), 7.01 (d, $J_{HH}$=3.7 Hz, 1H), 6.97 (s, 1H), 6.96 (d, $J_{HH}$=8.6 Hz, 2H), 6.83 (d, $J_{HH}$=8.9 Hz, 2H), 3.93 (t, $J_{HH}$=6.6 Hz, 4H), 2.74 (t, $J_{HH}$=8.1 Hz, 2H), 2.63 (t, $J_{HH}$=8.1Hz, 2H), 2.43 (t, $J_{HH}$=8.1 Hz, 2H), 1.87 (s, 12H), 1.78 (quint, $J_{HH}$=6.6 Hz, 4H), 1.57-1.68 (m, 4H), 1.23-1.53 (m, 40H), 0.83-0.96 (m, 18H)

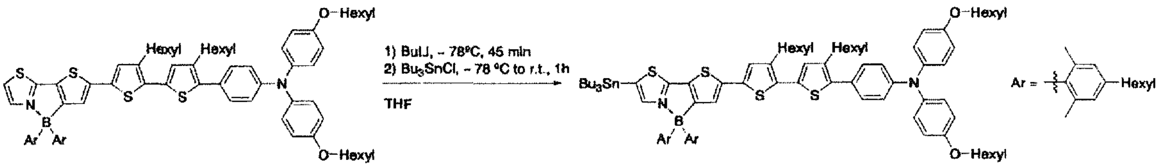


43 44

A THF (6 mL) solution of Compound 43 (789 mg, 0.592 mmol) was cooled to -78°C followed by dropping in a hexane solution of n-BuLi (1.58 M, 0.40 mL, 0.63 mmol). After stirring for 45 minutes while holding the temperature at -78°C, tributyltin chloride (0.20 mL, 0.74 mmol) was added followed by stirring for 1 hour while slowly raising the temperature to room temperature. After adding water, the organic layer was removed and the aqueous layer was extracted with hexane. The combined organic layer was sequentially washed with water, saturated sodium chloride and aqueous sodium chloride solution in that order, dried over anhydrous $Na_2SO_4$ and filtered followed by distilling off the solvent under reduced pressure. The mixture was purified by alumina column chromatography (developing solvent: hexane: dichloromethane = 10:1→5:1, $R_f$ = 0.43 (hexane: dichloromethane =5:1)) to obtain Compound 44 (686 mg, 0.423 mmol) in a yield of 72% as a viscous red liquid.

$^1$H-NMR (300 MHz, $CDCl_3$) δ7.52 (s, 1H), 7.23 (d, $J_{HH}$=8.6 Hz, 2H), 7.08 (d, $J_{HH}$=8.9 Hz, 4H), 7.02 (s, 1H), 6.97 (s, 1H), 6.92 (d, $J_{HH}$=8.6 Hz, 2H), 6.83 (d, $J_{HH}$=8.9 Hz, 2H), 3.93 (t, $J_{HH}$=6.6 Hz, 4H), 2.74 (t, $J_{HH}$=8.1 Hz, 2H), 2.63 (t, $J_{HH}$=8.1 Hz, 2H), 2.43 (t, $J_{HH}$=8.1 Hz, 2H), 1.87 (s, 12H), 1.78 (quint, $J_{HH}$=6.6 Hz, 4H), 1.57-1.68 (m, 10H), 1.20-1.53 (m, 46H), 1.12 (t, $J_{HH}$=7.8 Hz, 6H), 0.81-0.99 (m, 27H)

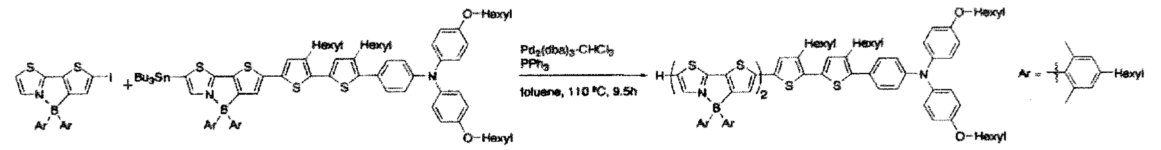


41 44 45

Compound 41 (287 mg, 0.421 mmol), Compound 44 (686 mg, 0.423 mmol), $Pd_2(dba)_3 \cdot CHCl_3$ (10.8 mg, 10.4 μmol) and $PPh_3$ (23.2 mg, 88 μmol) were dissolved in degassed anhydrous toluene (4 mL) in an argon atmosphere followed by stirring for 9.5 hours at 110°C. After cooling to room temperature and distilling off the solvent under reduced pressure, the mixture was purified by silica gel column chromatography (developing solvent: hexane: dichloromethane = 2 : 1 , $R_f$ = 0.25) and chloroform GPC to obtain Compound 45 (664 mg, 0.352 mmol) in a yield of 83% as a deep red solid.

$^1$H-NMR (300 MHz, $CDCl_3$) δ7.72 (d, $J_{HH}$=3.7 Hz, 1H), 7.69 (s, 1H), 7.23 (d, $J_{HH}$=8.6 Hz, 2H), 7.09 (d, $J_{HH}$=3.7 Hz, 1H), 7.08 (d, $J_{HH}$=8.9 Hz, 4H), 7.05 (s, 1H), 6.98 (s, 1H), 6.92 (d, $J_{HH}$=8.6 Hz, 2H), 6.84 (d, $J_{HH}$=8.9 Hz, 2H), 6.65 (s, 4H), 6.64 (s, 4H), 3.93 (t, $J_{HH}$=6.6 Hz, 4H), 2.74 (t, $J_{HH}$=8.1 Hz, 2H), 2.63 (t, $J_{HH}$=8.1 Hz, 2H), 2.43 (t, $J_{HH}$=8.1 Hz, 8H), 1.90 (s, 12H), 1.84 (s, 12H), 1.78 (quint, $J_{HH}$=6.6 Hz, 4H), 1.57-1.68 (m, 4H), 1.23-1.53 (m, 56H), 0.82-0.95 (m, 24H)

(3) Introduction of Anchor Site (A)

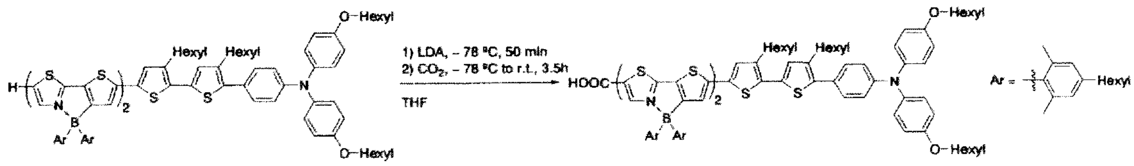


45 46

A THF (2 mL) solution of Compound 45 (289 mg, 0.153 mmol) was cooled to -78°C followed by dropping in a THF solution of LDA (0.606 M, 0.38 mL, 0.23 mmol). After stirring for 50 minutes at -78°C, dry ice (1.0 g, 23 mmol) was added followed by stirring for 3.5 hours while slowly raising the temperature to room temperature. After adding water, the organic layer was removed and the aqueous layer was extracted with hexane. The organic layer was dried over anhydrous $Na_2SO_4$ and filtered followed by distilling off the solvent under reduced pressure. The mixture was purified by silica gel column chromatography (developing solvent: hexane:ethyl acetate:ethanol = 5:1:1, $R_f$ = 0.18) to obtain Compound 46 (176 mg, 91.2 μmol) in a yield of 60% as a deep red solid.

$^1$H-NMR (300 MHz, $CDCl_3$/DMSO = 1/1) δ7.85 (brs, 1H), 7.67 (s, 1H), 7.21 (s, 1H), 7.17 (s, 1H), 7.16 (d, $J_{HH}$=8.6 Hz, 2H), 7.10 (s, 1H), 7.03 (d, $J_{HH}$=8.9 Hz, 4H), 6.97 (s, 1H), 6.84 (d, $J_{HH}$=8.6 Hz, 2H), 6.81 (d, $J_{HH}$=8.9 Hz, 4H), 6.57 (s, 4H), 6.53 (s, 4H), 3.90 (t, $J_{HH}$=6.6 Hz, 4H), 2.71 (m, 2H), 2.58 (m, 2H), 2.36 (m, 8H), 1.85 (s, 12H), 1.78 (s, 12H), 1.73 (quint, $J_{HH}$=6.6 Hz, 4H), 1.54-1.65 (m, 4H), 1.17-1.53 (m, 56H), 0.77-0.94 (m, 24H)

Example 10 (Synthesis of Compound)

(1) Introduction of Acceptor Site T into Donor Site

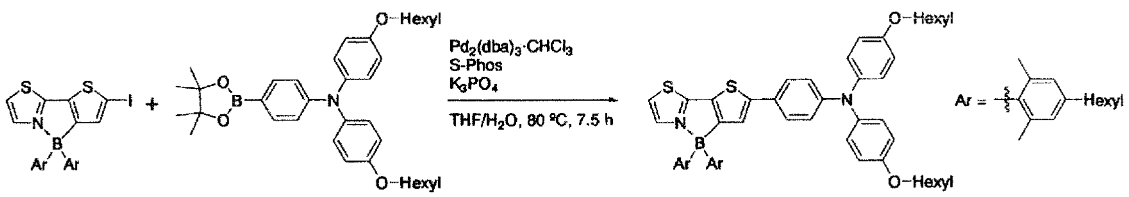


41 47 48

Compound 41 (1.36 g, 1.99 mmol), Compound 47 (1.16 g, 2.03 mmol), $Pd_2(dba)_3.CHCl_3$ (52 mg, 50 μmol), S-Phos (83 mg, 0.20 mmol) and $K_3PO_4$ (1.23 g, 5.80 mmol) were dissolved in degassed THF (10 mL) and water (5 mL) in an argon atmosphere followed by stirring for 7.5 hours at 80°C. After cooling to room temperature, the organic layer was removed and the aqueous layer was extracted with hexane. The combined organic layer was sequentially washed with water and saturated aqueous sodium chloride solution in that order, dried over anhydrous $Na_2SO_4$ and filtered followed by distilling off the solvent under reduced pressure. The mixture was purified by silica gel column chromatography (developing solvent: hexane:dichloromethane = 3:1→2:1, $R_f$ = 0.23) (hexane:dichloromethane = 3:1) to obtain Compound 48 (1.97 g, 1.93 mmol) in a yield of 97% as a viscous orange liquid.

$^1$H-NMR (300 MHz, $CDCl_3$) δ7.65 (d, $J_{HH}$=3.7 Hz, 1H), 7.38 (d, $J_{HH}$=8.6 Hz, 2H), 7.31 (s, 1H), 7.04 (d, $J_{HH}$=8.9 Hz, 4H), 6.97 (d, $J_{HH}$=3.7 Hz, 1H), 6.86 (d, $J_{HH}$=8.6 Hz, 2H), 6.82 (d, $J_{HH}$=8.9 Hz, 4H), 6.62 (s, 4H), 3.93 (t, $J_{HH}$=6.6 Hz, 4H), 2.42 (t, $J_{HH}$=8.1 Hz, 2H), 1.87 (s, 12H), 1.77 (quint, $J_{HH}$=6.6 Hz, 4H), 1.41-1.52 (m, 4H), 1.23-1.39 (m, 24H), 0.91 (t, $J_{HH}$=6.8 Hz, 6H), 0.87 (t,

$J_{HH}$=6.8 Hz, 6H)

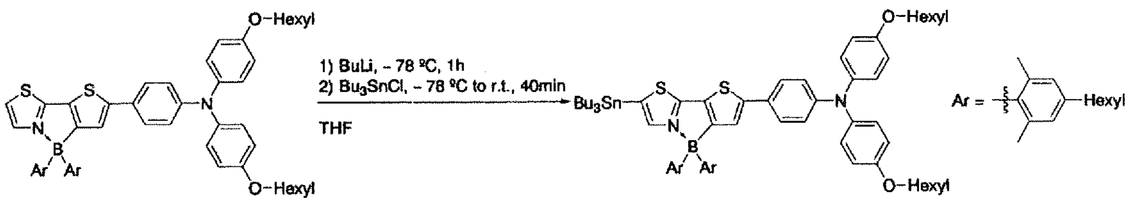


48 49

A THF (15 mL) solution of Compound 48 (1.19 g, 1.19 mmol) was cooled to -78°C followed by dropping in a hexane solution of *n*-BuLi (1.58 M, 1.0 mL, 1.58 mmol). After stirring for 1 hour at -78°C, tributyltin chloride (0.45 mL, 1.65 mmol) was added followed by stirring for 40 minutes while slowly raising the temperature to room temperature. After adding water, the organic layer was removed and the aqueous layer was extracted with hexane. The organic layer was sequentially washed with water and saturated aqueous sodium chloride solution in that order, dried over anhydrous $Na_2SO_4$ and filtered followed by distilling off the solvent under reduced pressure. The mixture was purified by alumina column chromatography (developing solvent: hexane:ethyl acetate = 40:1, $R_f$ = 0.46) to obtain Compound 49 (1.32 g, 1.02 mmol) in a yield of 86% as a viscous orange liquid.

$^1$H-NMR (300 MHz, $CDCl_3$) δ7.50 (s, 1H), δ7.38 (d, $J_{HH}$=8.6 Hz, 2H), 7.31 (s, 1H), 7.04 (d, $J_{HH}$=8.9 Hz, 4H), 6.86 (d, $J_{HH}$=8.6 Hz, 2H), > 6.82 (d, $J_{HH}$=8.9 Hz, 4H), 6.62 (s, 4H), 3.93 (t, $J_{HH}$=6.6 Hz, 4H), 2.42 (t, $J_{HH}$=8.1 Hz, 2H), 1.87 (s, 12H), 1.77 (quint, $J_{HH}$=5.6 Hz, 4H), 1.41-1.52 (m, 10H), 1.22-1.39 (m, 30H), 1.11 (t, $J_{HH}$=7.8 Hz, 6H), 0.83-0.96 (m, 21H)

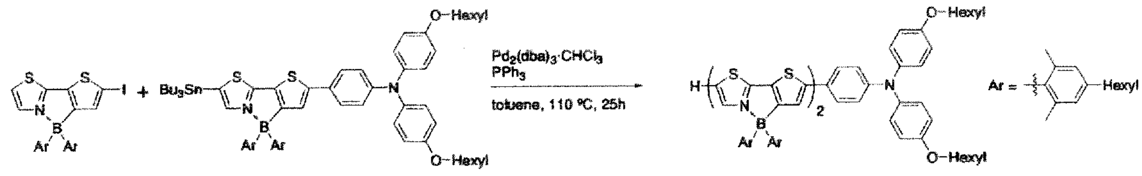


41 49 50

Compound 41 (698 mg, 1.02 mmol), Compound 49 (1.32 g, 1.02 mmol), $Pd_2(dba)_3 \cdot CHCl_3$ (27.2 mg, 26.3 μmol) and $PPh_3$ (53.8 mg, 0.205 mmol) were dissolved in degassed anhydrous toluene (6 mL) in an argon atmosphere followed by stirring for 25 hours at 110°C. After cooling to room temperature, the solvent was distilled off under reduced pressure. The mixture was purified by silica gel column chromatography (developing solvent: hexane:ethyl acetate = 20:1, $R_f$ = 0.26) to obtain Compound 50 (1.28 g, 0.825 mmol) in a yield of 81% as a deep red solid.

$^1$H-NMR (300 MHz, $CDCl_3$) δ7.71 (d, $J_{HH}$=3.7 Hz, 1H), 7.67 (s, 1H), 7.38 (d, $J_{HH}$=8.6 Hz, 2H), 7.30 (s, 1H), 7.20 (s, 1H), 7.08 (d, $J_{HH}$=3.7 Hz, 1H), 7.04 (d, $J_{HH}$=8.9 Hz, 4H), 6.85 (d, $J_{HH}$=8.6 Hz, 2H), 6.82 (d, $J_{HH}$=8.9 Hz, 4H), 6.64 (s, 8H), 3.93 (t, $J_{HH}$=6.6 Hz, 4H), 2.43 (t, $J_{HH}$=8.1 Hz, 8H), 1.90 (s, 12H), 1.84 (s, 12H), 1.77 (quint, $J_{HH}$=6.6 Hz, 4H), 1.41-1.52 (m, 8H), 1.23-1.39 (m, 36H), 0.83-0.96 (m, 18H)

<u>(2) Introduction of Anchor Site (A)</u>

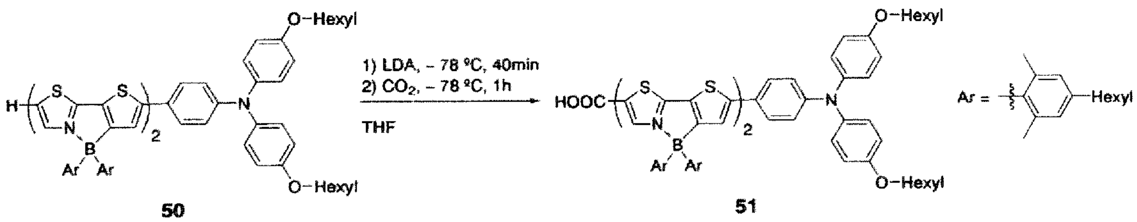


50 51

A THF (2 mL) solution of Compound 50 (369 mg, 0.238 mmol) was cooled to -78°C followed by dropping in a THF solution of LDA (0.606 M, 0.50 mL, 0.30 mmol). After stirring for 40 minutes at -78°C, dry ice (1.14 g, 26 mmol) was added followed by stirring for 1 hour while slowly raising the temperature to room temperature. After adding water, the organic layer was removed and the aqueous layer was extracted with hexane. The organic layer was dried over anhydrous $Na_2SO4$ and filtered followed by distilling off the solvent under reduced pressure. The mixture was purified

by PTLC (developing solvent: hexane:ethyl acetate:ethanol = 5:1:1, $R_f$ = 0.20) to obtain Compound 51 (204 mg, 0.128 mmol) in a yield of 54% as a deep red solid.

$^1$H-NMR (300 MHz, $CDCl_3$/DMSO = 1/1) δ7.79 (brs, 1H), 7.72 (s, 1H), 7.42 (d, $J_{HH}$=8.6 Hz, 2H), 7.26 (s, 2H), 7.02 (d, $J_{HH}$=8.9 Hz, 4H), 6.85 (d, $J_{HH}$=8.9 Hz, 4H), 6.78 (d, $J_{HH}$=8.6 Hz, 2H), 6.56 (s, 4H), 6.55 (s, 4H), 3.93 (t, $J_{HH}$=6.6 Hz, 4H), 2.37 (m, 8H), 1.86 (s, 12H), 1.79 (s, 12H), 1.73 (quint, $J_{HH}$=6.6 Hz, 4H), 1.41-1.52 (m, 8H), 1.23-1.39 (m, 36H), 0.83-0.96 (m, 18H)

Example 11 (Synthesis of Compound)

(1) Preparation of Donor Site and Acceptor Site T

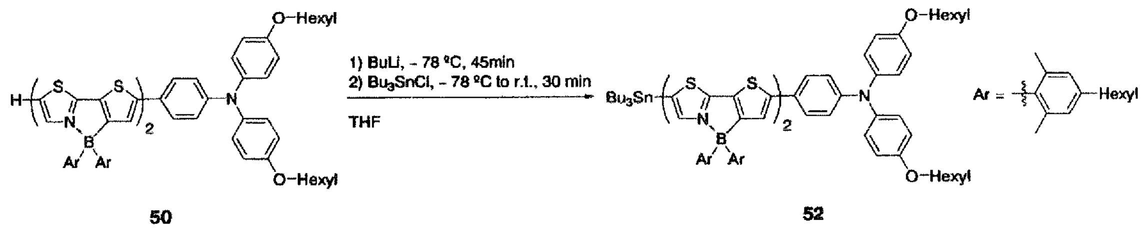


A THF (2.5 mL) solution of Compound 50 (369 mg, 0.238 mmol) was cooled to -78°C followed by dropping in a hexane solution of n-BuLi (1.58 M, 0.20 mL, 0.136 mmol). After stirring for 45 minutes while holding the temperature at -78°C, tributyltin chloride (0.10 mL, 0.368 mmol) was added followed by stirring for 30 minutes while slowly raising the temperature to room temperature. After adding water, the organic layer was removed and the aqueous layer was extracted with hexane. The organic layer was sequentially washed with water and saturated aqueous sodium chloride solution in that order, dried over anhydrous $Na_2SO_4$ and filtered followed by distilling off the solvent under reduced pressure. The mixture was purified by alumina column chromatography (developing solvent: hexane:dichloromethane = 10:1→5:1, $R_f$ = 0.38 (hexane: dichloromethane = 5:1)) to obtain Compound 52 (317 mg, 0.172 mmol) in a yield of 72% as a viscous red liquid.

$^1$H-NMR (300 MHz, $CDCl_3$) δ7.65 (s, 1H), 7.54 (s, 1H), 7.37 (d, $J_{HH}$=8.6 Hz, 2H), 7.30 (s, 1H), 7.19 (s, 1H), 7.04 (d, $J_{HH}$=8.9 Hz, 4H), 6.85 (d, $J_{HH}$=8.6 Hz, 2H), 6.82 (d, $J_{HH}$=8.9 Hz, 4H), 6.64 (s, 8H), 3.93 (t, $J_{HH}$=6.6 Hz, 4H), 2.43 (t, $J_{HH}$=8.1 Hz, 8H), 1.90 (s, 12H), 1.83 (s, 12H), 1.77 (quint, $J_{HH}$=6.6 Hz, 4H), 1.41-1.52 (m, 14H), 1.23-1.39 (m, 42H), 1.12 (t, $J_{HH}$=7.8 Hz, 6H), 0.83-0.96 (m, 27H)

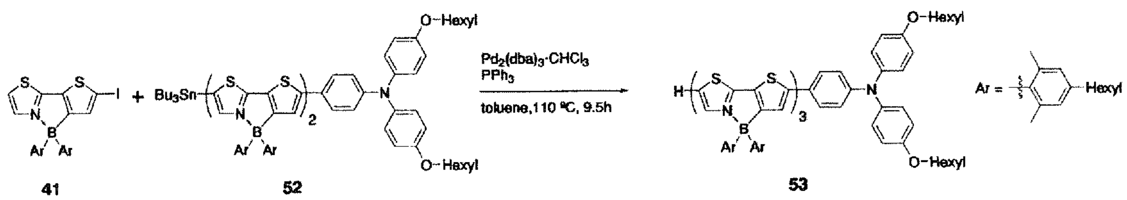


Compound 41 (117 mg, 0.172 mmol), Compound 52 (317 mg, 0.172 mmol), $Pd_2(dba)_3 \cdot CHCl_3$ (4.8 mg, 4.6 μmol) and $PPh_3$ (9.4 mg, 36 μmol) were dissolved in degassed anhydrous toluene (2 mL) in an argon atmosphere followed by stirring for 9.5 hours at 110°C. After cooling to room temperature, the solvent was distilled off under reduced pressure. The mixture was purified by alumina column chromatography (developing solvent: hexane:dichloromethane = 4:1, $R_f$ = 0.18) and toluene GPC to obtain Compound 53 (216 mg, 0.103 mmol) in a yield of 60% as a deep red solid.

$^1$H-NMR (300 MHz, $CDCl_3$) δ7.73 (d, $J_{HH}$=3.7 Hz, 1H), 7.71 (s, 1H), 7.68 (s, 1H), 7.37 (d, $J_{HH}$=8.6 Hz, 2H), 7.30 (s, 1H), 7.22 (s, 1H), 7.17 (s, 1H), 7.11 (d, $J_{HH}$=3.7 Hz, 1H), 7.04 (d, $J_{HH}$=8.9 Hz, 4H), 6.85 (d, $J_{HH}$=8.6 Hz, 2H), 6.82 (d, $J_{HH}$=8.9 Hz, 4H), 6.64 (s, 4H), 6.64 (s, 8H), 3.93 (t, $J_{HH}$=6.6 Hz, 4H), 2.43 (t, $J_{HH}$=8.1 Hz, 12H), 1.90 (s, 12H), 1.87 (s, 12H), 1.83 (s, 12H), 1.77 (quint, $J_{HH}$=6.6 Hz, 4H), 1.41-1.52 (m, 12H), 1.23-1.39 (m, 48H), 0.83-0.96 (m, 24H)

(2) Introduction of Anchor Site A

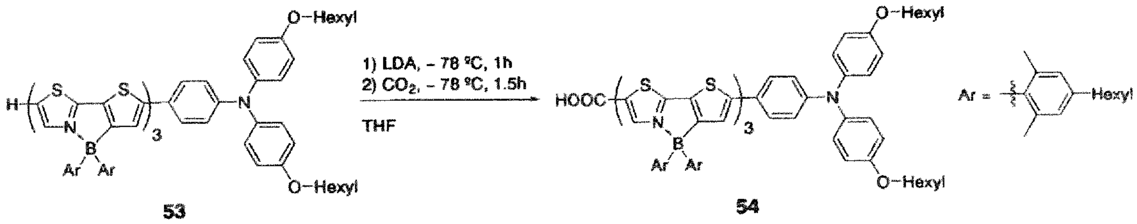


53

54

A THF (2 mL) solution of Compound 53 (216 mg, 0.103 mmol) was cooled to -78°C followed by dropping in a THF solution of LDA (0.606 M, 0.25 mL, 0.15 mmol). After stirring for 1 hour at - -78°C, dry ice (1.1 g, 25 mmol) was added followed by stirring for 1.5 hours while slowly raising the temperature to room temperature. After adding water, the organic layer was removed and the aqueous layer was extracted with hexane. The organic layer dried over anhydrous $Na_2SO_4$ and filtered followed by distilling off the solvent under reduced pressure. The mixture was purified by silica gel column chromatography (developing solvent: dichloromethane:ethanol = 1:0→10:1→4:1, $R_f$ = 0.10 (dichloromethane: ethanol= 10:1)) to obtain Compound 54 (18 mg, 8.37 μmol) in a yield of 8% as a deep red-violet solid.

$^1$H-NMR (300 MHz, $CDCl_3$/DMSO = 1/1) δ7.98 (brs, 1H), 7.72 (s, 1H), 7.66 (s, 1H), 7.35 (d, $J_{HH}$=8.6 Hz, 2H), 7.23 (s, 1H), 7.23 (s, 1H), 7.18 (s, 1H), 7.00 (d, $J_{HH}$=8.9 Hz, 4H), 6.80 (d, $J_{HH}$=8.9 Hz, 4H), 6.78 (d, $J_{HH}$=8.6 Hz, 2H), 6.56 (s, 4H), 6.55 (s, 8H), 3.90 (t, $J_{HH}$=6.6 Hz, 4H), 2.36 (t, $J_{HH}$=6.9 Hz, 12H), 1.84 (s, 12H), 1.82 (s, 12H), 1.78 (s, 12H), 1.72 (quint, $J_{HH}$=6.6 Hz, 4H), 1.41-1.52 (m, 12H), 1.23-1.39 (m, 48H), 0.78-0.92 (m, 24H)

Experiment Example 1 (Production of Dye-Sensitized Solar Cell)

(1) Fabrication of Light-Absorbing Layer

Titania paste (Solaronix SA, Ti-NanoxideT/SP Titania Paste) was coated onto an electrically conductive substrate (surface resistance: 10 Ω/, 15 mm x 25 mm, glass substrate with fluorine-doped tin oxide film) using a known screening printing method, and after repeating a procedure consisting of drying for 3 minutes at 120°C ten times, the electrically conductive substrate was baked for 30 minutes at 500°C to form a porous titanium oxide film having a thickness of 18 μm to 20 μm.

Next, after immersing the above-mentioned electrically conductive substrate having the porous titanium oxide film formed thereon in a solution obtained by respectively dissolving Compound 19 obtained in Example 1 in THF, 1/4 THF-ethanol mixture or acetone solvent to a concentration of 100 μM for 10 hours at 30°C, the substrate was washed with the solvent respectively used for each solution at room temperature to obtain an electrically conductive substrate having a light-absorbing layer.

(2) Fabrication of Dye-Sensitized Solar Cell

A counter electrode was fabricated by depositing platinum at a film thickness of about 1 nm on an ITO glass substrate having two electrolyte injection holes having a diameter of about 0.7 mm.

A frame-type ionomer resin having a thickness of about 30 μm was adhered as a spacer on the electrically conductive substrate having a light-absorbing layer obtained in (1) above, and the counter electrode was adhered thereon. Next, an electrolyte solution obtained by dissolving 0.1 M lithium iodide, 0.025 M iodine, 0.6 M DMPII (dimethylpropylimidazolium iodide) and 0.5 M TBP (4-tert-butylpyridine) in acetonitrile was prepared, and this electrolyte solution was injected inside through the above-mentioned electrolyte injection holes to fabricate a dye-sensitized solar cell.

Test Example 1

Compounds 19, 23 and 31 obtained in the above-mentioned Examples 1, 4 and 6 were respectively dissolved in THF to obtain 5 x $10^{-5}$ M solutions, followed by measurement of their UV-visible absorption spectra using the UV-Vis Shimadzu UV-3150 PC. The results are shown in Figs. 1 to 3.

In addition, the UV-visible absorption spectrum was similarly measured for the above-mentioned electrically conductive substrate having a light-absorbing layer obtained in (1) of Experiment Example 1. For comparison, the UV-visible absorption spectrum was similarly measured for the above-mentioned porous titanium oxide film adhered with dye obtained in (1) of Experiment Example 1. The results are shown in Fig. 4.

Test Example 2

Photoelectric conversion efficiency was measured according to the method indicated below using the CEP25TF Spectrometer for the above-mentioned dye-sensitized solar cell obtained in Experiment Example 1.
For comparison, after immersing the above-mentioned electrically conductive substrate having the porous titanium oxide film formed thereon in a saturated 1:1 *tert*-butyl alcohol and acetonitrile mixed solution of a known dye in the form of bis-tetrabutylammonium *cis*-bis(isothiocyanato)bis(2,2'-bipyridyl-4,4'-dicarboxylat o) ruthenium(II) (to be referred to as N719) for 20 hours at 30°C, the substrate was washed with the mixed solvent used at room temperature, and the resulting light-absorbing layer was also measured in the same manner.

<Measurement Method>

The dye-sensitized solar cells were measured using a method in compliance with the measuring method of output power for silicon crystalline solar cells described in JIS C8913:1998. An Air Mass Filter equivalent to AM 1.5 G was combined with a 300 W Solar Simulator (Yamashita Denso Corp. , Model YSS-80) for use as a measurement light source by adjusting to an intensity of 100 mW/cm$^2$ with a secondary reference Si solar cell, and I-V curve characteristics were measured using a potentiostat (Hokuto Denko Corp., Model HSV-100) while radiating light onto a test sample of the dye-sensitized solar cell followed by calculating open voltage ($V_{oc}$), short-circuit current ($I_{sc}$) and fill factor (FF) obtained from measurement of I-V curve characteristics. Short-circuit current density ($J_{sc}$) and photoelectric conversion efficiency ($\eta$) were then calculated using the following Equations 1 and 2. The results obtained are shown in Table 1.

[Math. 1]

$$\text{Short-circuit current density } (J_{sc})\ (\text{mA/cm}^2) = I_{sc}\ (\text{mA})/\text{effective light receiving surface area S } (\text{cm}^2)$$

[Math. 2]

$$\text{Photoelectric conversion efficiency } (\eta)\ (\%) = V_{oc}\ (\text{V}) \times J_{sc}\ (\text{mA/cm}^2) \times \text{FF} \times 100/100\ (\text{mW/cm}^2)$$

[Table 1]

| Solvent | $V_{oc}$/V | $J_{sc}$/mA cm$^{-2}$ | FF | $\eta$/% |
|---|---|---|---|---|
| THF | 0.712 | 11.1 | 0.720 | 5.68 |
| Ethanol/THF (4/1) | 0.736 | 12.2 | 0.667 | 5.99 |
| Acetone | 0.724 | 5.73 | 0.618 | 2.57 |
| N719 (comparison) | 0.736 | 18.2 | 0.606 | 8.11 |
| $V_{oc}$: open voltage, $J_{sc}$: short-circuit current, FF: fill factor (curve factor), $\eta$: photoelectric conversion efficiency | | | | |

Example 3

The incident photon-to-current conversion efficiency (IPCE) spectrum of the dye-sensitized solar cell obtained in Experiment Example 1 above was measured over a range from 300 nm to 900 nm using the CEP25TF Spectrometer.
In addition, IPCE spectrum was also measured for a light-absorbing layer using N719 in the same manner as the above-mentioned Test Example 2 for comparison.
As shown in Fig. 5, a trough was observed in the vicinity of 480 nm in the case of the dye-sensitized solar cell fabricated from an acetone solution. In addition, the dye-sensitized solar cells fabricated from THF solution and a mixed solution of THF and ethanol demonstrated high incident photon-to-current conversion efficiency (IPCE) corresponding to the absorption wavelength of Compound 19, and IPCE spectra greater than 90% were obtained in the region from 410 nm to 550 nm.

Test Example 4

Dye-sensitized solar cells were fabricated that were obtained by not adding TBP (4-*tert*-butylpyridine), or by adding TBP at concentrations of 0.1 M, 0.3 M and 0.5 M, to a dye-sensitized solar cell having a light-absorbing layer adsorbed thereon by immersing a thin film of titanium dioxide into the THF solution of Compound 19 obtained in Example 1 in the same manner as described in Test Example 1. Measurements were carried out in the same manner as Test Example 2 using these dye-sensitized solar cells, and a study was made of the effects of the addition of TBP on open voltage ($V_{oc}$) and short-circuit current ($I_{sc}$).

As shown in Fig. 6, as the added amount of TBP increased from 0.1 M to 0.3 M to 0.5 M, open voltage and short-circuit current were determined to increase.

Brief Description of Drawings

Fig. 1 indicates the ultraviolet-visible absorption spectrum of a compound obtained in Example 1 of the present application in THF solution;

Fig. 2 indicates the ultraviolet-visible absorption spectrum of a compound obtained in Example 4 of the present application in THF solution;

Fig. 3 indicates the ultraviolet-visible absorption spectrum of a compound obtained in Example 6 of the present application in THF solution;

Fig. 4 indicates the ultraviolet-visible absorption spectrum of a compound obtained in Example 1 of the present application while adhered to titanium oxide, and the type of solvent described in the drawing indicates the solvent used when adsorbing on the titanium oxide;

Fig. 5 indicates the IPCE spectrum of a dye-sensitized solar cell that uses a compound obtained in Example 1 of the present application for the dye; and

Fig. 6 indicates the effect of adding TBP on I-V characteristics of a dye-sensitized solar cell that uses a compound obtained in Example 1 of the present application for the dye.

## Claims

1. A dye for a dye-sensitized solar cell, comprising:

   a compound having an anchor site A capable of bonding to a semiconductor electrode of an organic solar cell, and an acceptor site T bonding to the anchor site and having a $\pi$-conjugated backbone that has a boron-containing substituent represented by the formula: $-B(X^1)(-X^2)$ (wherein $X^1$ and $X^2$ independently represent substituents), the $\pi$-conjugated backbone having as a constituent atom thereof a heteroatom that forms a double bond with carbon in the end region on the side of the anchor backbone and is coordinate-bonded to the boron of the boron-containing substituent.

2. The dye according to claim 1, wherein the compound is a compound having an acceptor site T and an anchor site A represented by the following general formula (1):

   A-T (1)

   (wherein T is composed of one or more partial structures represented by the following chemical formula (2a) or (2b) and having an intramolecular coordination bond to boron, and in the case where the number of the partial structures is two or more, adjacent partial structures are independent in each linkage and may be coupled directly based on any coupling scheme selected from $Ar^1$-$Ar^2$, $Ar^1$-$Ar^1$ and $Ar^2$-$Ar^2$,

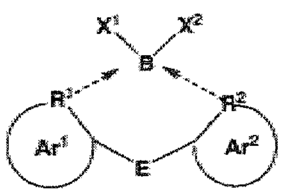 (2 a)

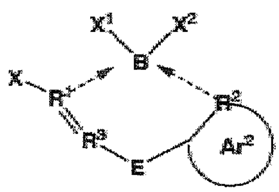 (2 b)

(wherein $Ar^1$ and $Ar^2$ respectively and independently represent one type selected from the group consisting of substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted benzothiazole, substituted or unsubstituted benzo (bis)thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, and substituents on $Ar^1$ and $Ar^2$ may also bond to form a ring in formula (2a),
$R^1$ and $R^2$ respectively and independently represent one type selected from the group consisting of carbon, nitrogen and phosphorous, at least one of these is nitrogen or phosphorous having a coordination bond to boron, and $R^1$ represents nitrogen or phosphorous in formula (2b),
dotted-line arrows represent bonds that may be coordination bonds,
$R^3$ represents a carbon atom bonded to the anchor site A, X, $X^1$ and $X^2$ respectively and independently represent one type selected from the group consisting of a hydrogen, halogen, substituted or unsubstituted alkyl group, substituted or unsubstituted aryl group, substituted or unsubstituted heteroaryl group, substituted or unsubstituted alkenyl group, substituted or unsubstituted alkynyl group, substituted or unsubstituted amino group, substituted or unsubstituted alkoxy group, substituted or unsubstituted arylalkoxy group and hydroxyl group, or a substituted or unsubstituted 2,2'-biphenyl group or substituted or unsubstituted 2,2'-bithienyl group obtained by bonding of $X^1$ and $X^2$, and E represents one type selected from the group consisting of a direct bond, -CR=CR-, =CR-, >C=O, =N-, -NR-, -O- , -S- , -PR-, =P- and -P(O)R-, wherein R independently represents at the time of each appearance at least one type selected from the group consisting of a hydrogen, alkyl group, alkoxy group, alkylthio group, aryl group, heteroaryl group, polyethylenedioxy group, perfluoroalkyl group, cyano group, amino group, silyl group, nitro group, halogen and acyl group); and,
A represents a group capable of bonding to a semiconductor electrode that bonds on $Ar^1$ on the end of the acceptor site T, and is one type selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group; and an alkoxy group, alkyl group, alkenyl group, alkynyl group, cycloalkyl group, aryl group, heteroaryl group and dioxocyclobutenyl group having at least one functional group selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group).

**3.** The dye according to claim 1 or 2, wherein the acceptor site T in formula (1) contains a donor site D having an electron-donating backbone on the end on the opposite site to the anchor site A.

**4.** The dye according to claim 3, wherein the donor site D is at least one type selected from the group consisting of a triarylamine derivative, carbazole derivative, substituted or unsubstituted aryl group, substituted or unsubstituted amino group, substituted or unsubstituted arylalkoxy group and substituted or unsubstituted arylthioalkoxy group.

**5.** The dye according to claim 3 or 4, wherein the acceptor site T in formula (1) contains a spacer site Q having a $\pi$-conjugated backbone between the acceptor site T and the donor site D.

**6.** The dye according to claim 5, wherein the spacer site Q is at least one type selected from the group consisting of an alkenyl group, alkynyl group, substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, or substituents on Q may bond to form a ring.

**7.** A photovoltaic method comprising exposing to light a compound having an anchor backbone capable of bonding to a semiconductor electrode of an organic solar cell, and a $\pi$-conjugated backbone that bonds to the anchor backbone and contains one or more boron atoms as constituent atoms thereof, this $\pi$-conjugated backbone containing an intramolecular coordination bond to boron in the end region on the side of the anchor backbone.

**8.** A compound having an acceptor site T and an anchor site A represented by the following general formula (1):

A-T (1)

(wherein T is composed of one or more partial structures represented by the following chemical formula (2a) or (2b) and having an intramolecular coordination bond to boron, and in the case where the number of the partial structures is two or more, adjacent partial structures are independent in each linkage and may be coupled directly based on any coupling scheme selected from $Ar^1$-$Ar^2$, $Ar^1$-$Ar^1$ and $Ar^2$-$Ar^2$,

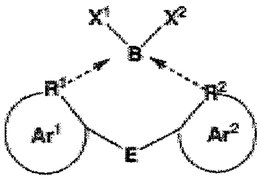
(2 a)

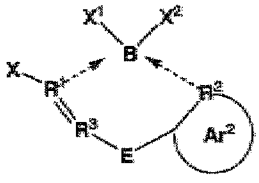
(2 b)

(wherein $Ar^1$ and $Ar^2$ respectively and independently represent one type selected from the group consisting of substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted benzothiazole, substituted or unsubstituted benzo (bis)thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, and substituents on $Ar^1$ and $Ar^2$ may also bond to form a ring in formula (2a),
$R^1$ and $R^2$ respectively and independently represent one type selected from the group consisting of carbon, nitrogen and phosphorous, at least one of these is nitrogen or phosphorous having a coordination bond to boron, and $R^1$ represents nitrogen or phosphorous in formula (2b),
dotted-line arrows represent bonds that may be coordination bonds,
$R^3$ represents a carbon atom bonded to the anchor site A,
X, $X^1$ and $X^2$ respectively and independently represent one type selected from the group consisting of a hydrogen, halogen, substituted or unsubstituted alkyl group, substituted or unsubstituted aryl group, substituted or unsubstituted heteroaryl group, substituted or unsubstituted alkenyl group, substituted or unsubstituted alkynyl group, substituted or unsubstituted amino group, substituted or unsubstituted alkoxy group, substituted or unsubstituted arylalkoxy group and hydroxyl group, or a substituted or unsubstituted 2,2'-biphenyl group or substituted or unsubstituted 2,2'-bithienyl group obtained by bonding of $X^1$ and $X^2$, and
E represents one type selected from the group consisting of a direct bond, -CR=CR-, =CR-, >C=O, =N-, -NR-, -O-, -S-, -PR-, =P- and -P(O)R-, wherein R independently represents at the time of each appearance at least one type selected from the group consisting of a hydrogen, alkyl group, alkoxy group, alkylthio group, aryl group, heteroaryl group, polyethylenedioxy group, perfluoroalkyl group, cyano group, amino group, silyl group, nitro group, halogen and acyl group)); and,
A represents a group capable of bonding to a semiconductor electrode and bonding on $Ar^1$ on the end of the acceptor site T, and is one type selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group; and an alkoxy group, alkyl group, alkenyl group, alkynyl group, cycloalkyl group, aryl group, heteroaryl group and dioxocyclobutenyl group having at least one functional group selected from the group consisting of a carboxyl group, boronic acid group, phosphoryl group, sulfonic acid group, sulfonyl group, hydroxyl group, hydroxamic acid group, alkoxy group, nitro group, amino group, mercapto group, silyl group, siloxy group, azido group and cyanoacrylate group).

9. The compound according to claim 8, wherein the acceptor site T in formula (1) contains a donor site D having an electron-donating backbone on the end on the opposite site to the anchor site A.

10. The compound according to claim 9, wherein the donor site D is at least one type selected from the group consisting of a triarylamine derivative, carbazole derivative, substituted or unsubstituted aryl group, substituted or unsubstituted amino group, substituted or unsubstituted arylalkoxy group and substituted or unsubstituted arylthioalkoxy group.

11. The compound according to claim 9 or 10, wherein the acceptor site T in formula (1) contains a spacer site Q having a $\pi$-conjugated backbone between the acceptor site T and the donor site D.

12. The compound according to claim 11, wherein the spacer site Q is at least one type selected from the group consisting of an alkenyl group, alkynyl group, substituted or unsubstituted benzene, substituted or unsubstituted heterole, substituted or unsubstituted heterole oxide, substituted or unsubstituted benzoheterole, substituted or unsubstituted benzoheterole oxide, substituted or unsubstituted dibenzoheterole, substituted or unsubstituted dibenzoheterole oxide, substituted or unsubstituted fluorene derivative, substituted or unsubstituted dithienoheterole, substituted or unsubstituted dithienoheterole oxide, substituted or unsubstituted thienoheterole, substituted or unsubstituted thienoheterole oxide, substituted or unsubstituted benzodiheterole, substituted or unsubstituted benzodiheterole oxide, substituted or unsubstituted acene, substituted or unsubstituted thiazole, substituted or unsubstituted oxazole, substituted or unsubstituted benzothiadiazole, substituted or unsubstituted imidazole, substituted or unsubstituted pyrazole, substituted or unsubstituted pyridine, substituted or unsubstituted pyrimidine, substituted or unsubstituted pyridazine, substituted or unsubstituted quinoline and substituted or unsubstituted isoquinoline, or substituents on Q may bond to form a ring.

13. A dye composed of any of the compounds according to claims 8 to 12.

14. A dye-sensitized solar cell, comprising:

a first electrode,
a light-absorbing layer formed on one side of the first electrode,
a second electrode arranged opposite the first electrode on which the light-absorbing layer is formed, and
a charge transport material positioned between the first electrode and the second electrode, wherein
the light-absorbing layer contains a metal oxide and the dye according to claim 13.

Fig. 1

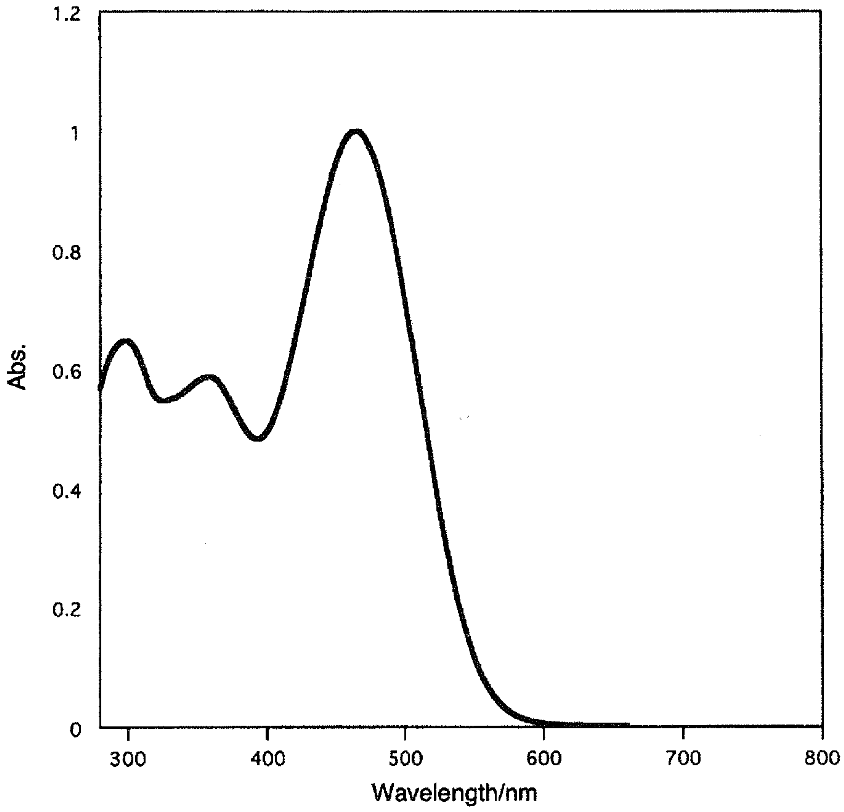
1.2
1
0.8
0.6
0.4
0.2
0
Abs.
300
400
500
600
700
800
Wavelength/nm

Fig. 2

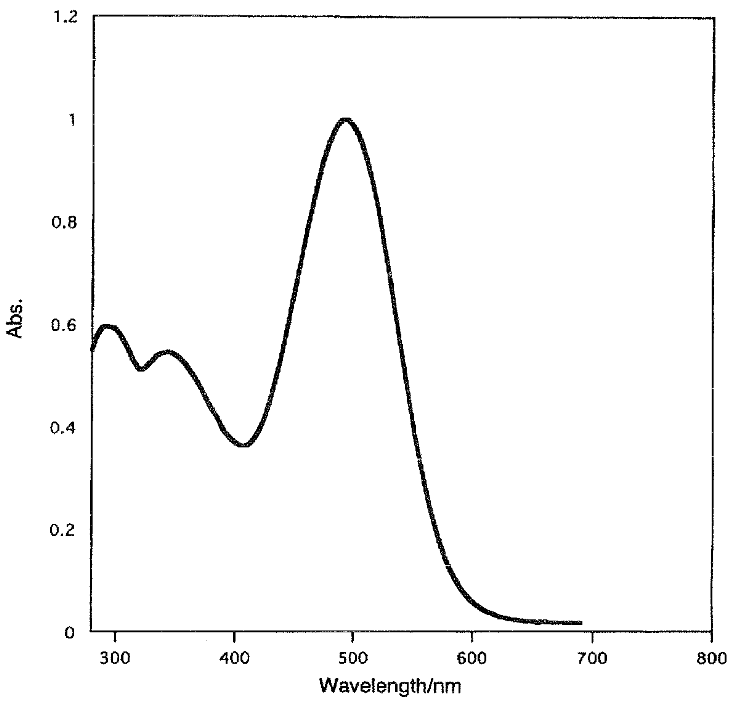
1.2
1
0.8
0.6
0.4
0.2
0
Abs.
300
400
500
600
700
800
Wavelength/nm

Fig. 3

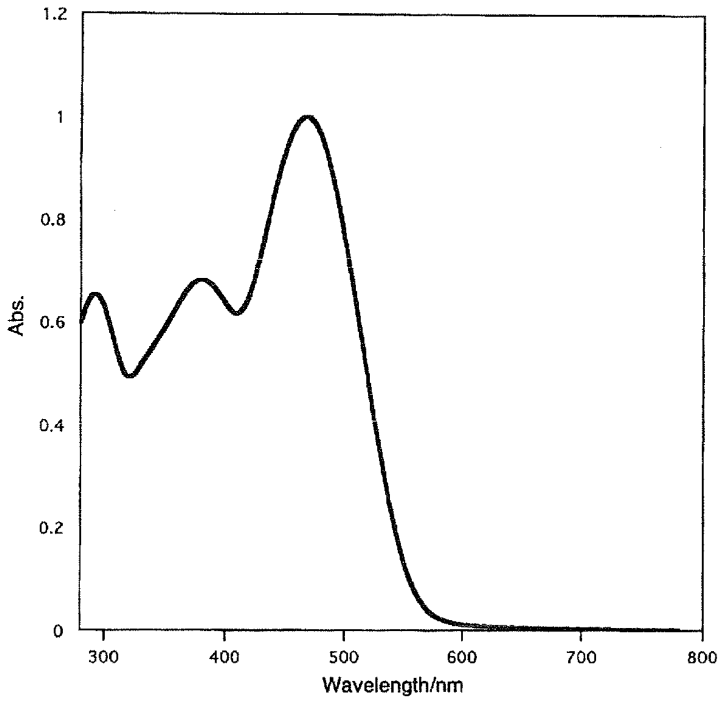
1.2
1
0.8
0.6
0.4
0.2
0
Abs.
300
400
500
600
700
800
Wavelength/nm

Fig. 4

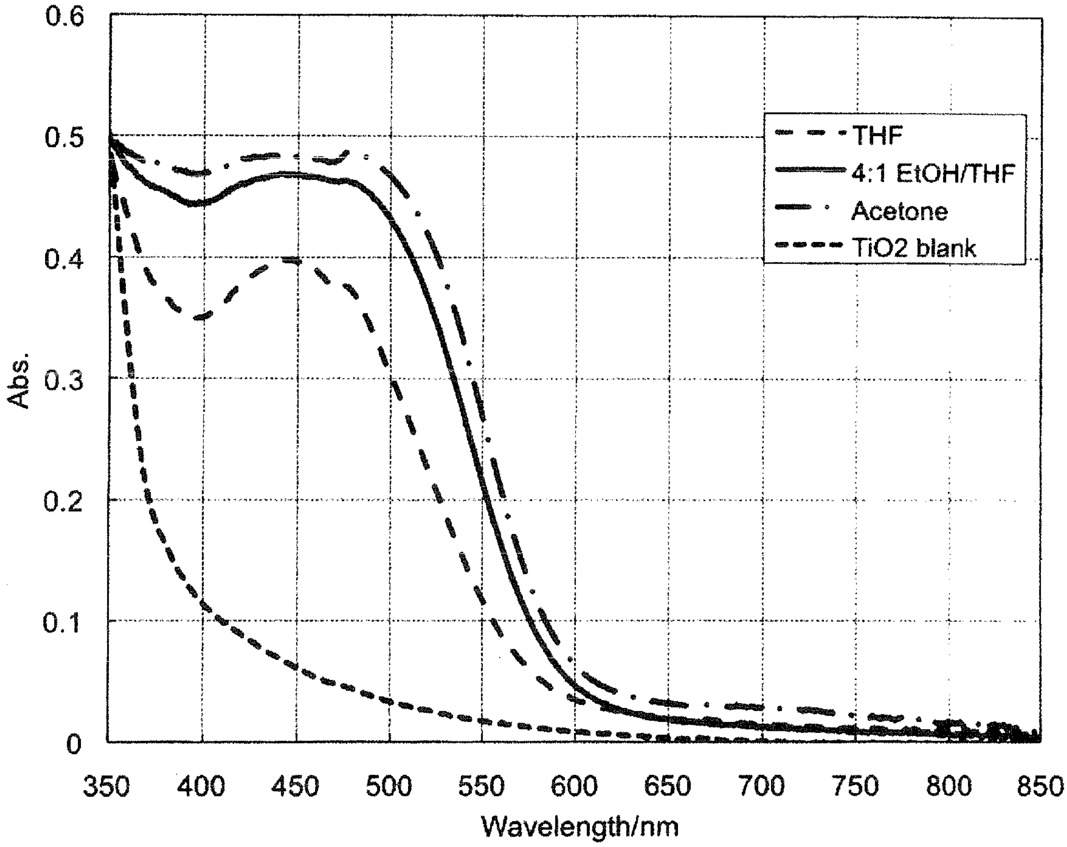
0.6
0.5
0.4
0.3
0.2
0.1
0
Abs.
350
400
450
500
550
600
650
700
750
800
850
Wavelength/nm
THF
4:1 EtOH/THF
Acetone
TiO2 blank

Fig.5

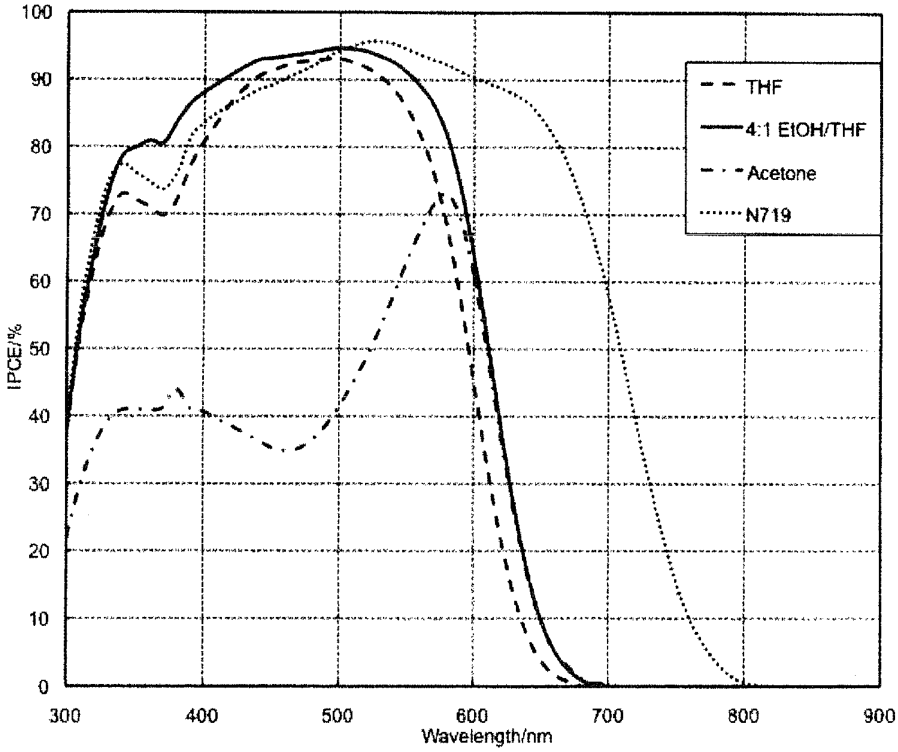
100
90
80
70
60
50
40
30
20
10
0
IPCE/%
300
400
500
600
700
800
900
Wavelength/nm
THF
4:1 EtOH/THF
Acetone
N719

Fig. 6

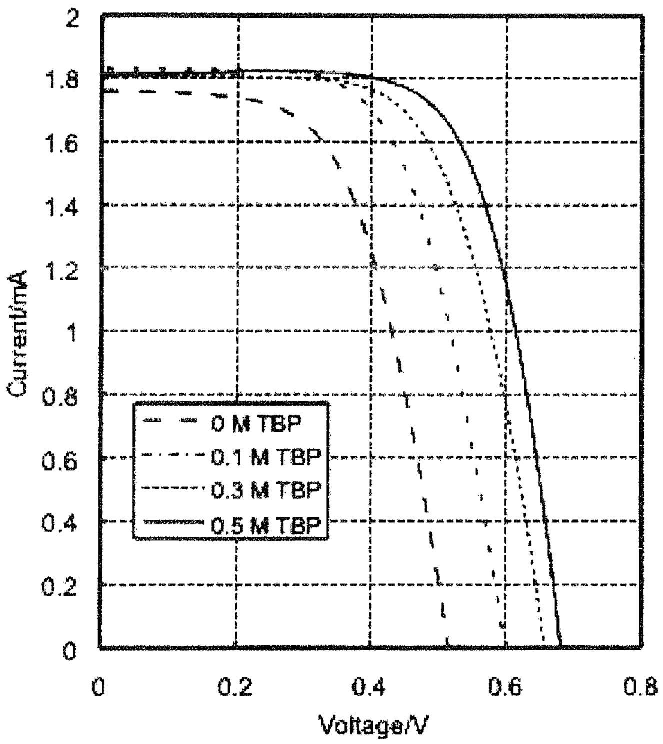
2
1.8
1.6
1.4
1.2
1
0.8
0.6
0.4
0.2
0
Current/mA
0
0.2
0.4
0.6
0.8
Voltage/V
0 M TBP
0.1 M TBP
0.3 M TBP
0.5 M TBP

**INTERNATIONAL SEARCH REPORT**

International application No.
PCT/JP2012/056205

A. CLASSIFICATION OF SUBJECT MATTER
*H01M14/00*(2006.01)i, *C09B57/00*(2006.01)i, *H01L31/04*(2006.01)i

According to International Patent Classification (IPC) or to both national classification and IPC

B. FIELDS SEARCHED

Minimum documentation searched (classification system followed by classification symbols)
H01M14/00, C09B57/00, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
JMEDPlus(JDreamII), JST7580(JDreamII)

C. DOCUMENTS CONSIDERED TO BE RELEVANT

| Category* | Citation of document, with indication, where appropriate, of the relevant passages | Relevant to claim No. |
|---|---|---|
| X<br>A | Shigeki Hattori et al., Charge Separation in a Nonfluorescent Donor-Acceptor Dyad Derived from Boron Dipyrromethene Dye, Leading to Photocurrent Generation, J.Phys.Chem.B, 2005, Vol.109, P.15368-15375 | 1,3,4,7<br>2,5,6,8-14 |
| X<br>A | JP 2010-54242 A (Aquas Corp.), 11 March 2010 (11.03.2010), claims; paragraphs [0033], [0034] (Family: none) | 8,13<br>1-7,9-12,14 |
| A | Theodulf Rousseau et al., Multi-donor molecular bulk heterojunction solar cells: improving conversion efficiency by synergistic dye combinations, J.Mater. Chem., 2009, Vol.19, No.16, P.2298-2300 | 1-14 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
18 May, 2012 (18.05.12)

Date of mailing of the international search report
05 June, 2012 (05.06.12)

Name and mailing address of the ISA/
Japanese Patent Office

Facsimile No.

Authorized officer

Telephone No.

Form PCT/ISA/210 (second sheet) (July 2009)

**INTERNATIONAL SEARCH REPORT**

International application No.
PCT/JP2012/056205

C (Continuation). DOCUMENTS CONSIDERED TO BE RELEVANT

| Category* | Citation of document, with indication, where appropriate, of the relevant passages | Relevant to claim No. |
|---|---|---|
| P,A | Yuji KUBO, Kazuki WATANABE, Ryuhei NISHIYABU, Rieko HATA, Kazushi OTA, "Yuki Usumaku Taiyo Denchi eno Tekiyo o Shiko shita Thiophene Donyu-gata Dipyrromethene-kei Kinsekigai Kyushu Shikiso no Gosei", CSJ: The Chemical Society of Japan Koen Yokoshu, 11 March 2011 (11.03.2011), vol.91, no.4, page 1536 | 1-14 |

Form PCT/ISA/210 (continuation of second sheet) (July 2009)

**INTERNATIONAL SEARCH REPORT**

International application No.
PCT/JP2012/056205

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The inventions described in claims 1-6 are linked through only the matter described in claim 1, and the inventions described in claims 1 and 7-14 are linked through only a matter, i.e., a compound having an acceptor moiety (T) and an anchor moiety (A). However, these matters are disclosed in the prior art document shown below. Therefore, it is obvious that there is not any special technical feature that links a group of inventions described in claims 1-14 so as to form a single general inventive concept.

(continued to extra sheet)

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

INTERNATIONAL SEARCH REPORT

International application No.
PCT/JP2012/056205

Continuation of Box No.III of continuation of first sheet(2)

[List of prior art document]
Shigeki Hattori et al., Charge Separation in a Nonfluorescent Donor-Acceptor Dyad Derived from Boron Dipyrromethene Dye, Leading to Photocurrent Generation, J. Phys. Chem. B, 2005, Vol.109, P.15368-15375

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2006070817 A


### Non-patent literature cited in the description


- **AMARESH MISHRA ; MARKUS K.R. FISCHER ; PETER BAUERLE.** *Angew. Chem. Int. Ed.,* 2009, vol. 48, 2474-2499